(19) Europäisches Patentamt
European Patent Office
Office européen des brevets

(11) **EP 4 632 797 A1**

(12) **EUROPEAN PATENT APPLICATION**
published in accordance with Art. 153(4) EPC

(43) Date of publication:
**15.10.2025 Bulletin 2025/42**

(21) Application number: **23900578.8**

(22) Date of filing: **01.12.2023**

(51) International Patent Classification (IPC):
*H01L 21/365* (2006.01)   *C23C 16/40* (2006.01)
*C30B 29/16* (2006.01)   *H01L 21/329* (2006.01)
*H01L 21/338* (2006.01)   *H01L 21/36* (2006.01)
*H01L 21/368* (2006.01)   *H01L 29/12* (2006.01)
*H01L 29/739* (2006.01)   *H01L 29/778* (2006.01)
*H01L 29/78* (2006.01)   *H01L 29/812* (2006.01)
*H01L 29/872* (2006.01)   *H01L 33/26* (2010.01)

(52) Cooperative Patent Classification (CPC):
**C23C 16/40; C30B 29/16; H01L 21/02107;
H10D 8/60; H10D 12/00; H10D 30/061;
H10D 30/47; H10D 30/60; H10D 30/87;
H10D 48/021; H10D 62/81; H10D 62/83;
H10H 20/822**

(86) International application number:
**PCT/JP2023/043114**

(87) International publication number:
**WO 2024/122463 (13.06.2024 Gazette 2024/24)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **06.12.2022 JP 2022195220**

(71) Applicant: **SHIN-ETSU CHEMICAL CO., LTD.
Tokyo 1000005 (JP)**

(72) Inventor: **SAKATSUME, Takahiro
Annaka-shi, Gunma 379-0195 (JP)**

(74) Representative: **Schicker, Silvia
Wuesthoff & Wuesthoff
Patentanwälte und Rechtsanwalt PartG mbB
Schweigerstraße 2
81541 München (DE)**

(54) **CRYSTALLINE OXIDE SEMICONDUCTOR FILM, LAMINATED STRUCTURE, AND SEMICONDUCTOR DEVICE**

(57)   The present invention is a crystalline oxide semiconductor film that is a uniaxially oriented film containing $\alpha$-$Ga_2O_3$ as a main component, wherein a total area (C2) of peaks of a rotational domain with respect to a total area (C1) of peaks of the crystalline oxide semiconductor film, which are obtained by $\varphi$ scan of X-ray diffraction measurement of an asymmetric plane of the crystalline oxide semiconductor film, is the total area (C2) of the peaks of the rotational domain being less than 5 counts with respect to 1,000,000 counts of the total area (C1) of the peaks of the crystalline oxide semiconductor film. Thereby, the crystalline oxide semiconductor film is provided that has satisfactory crystallinity in which the rotational domain is more reduced, and is useful particularly for a semiconductor device.

FIG. 1

**Description**

TECHNICAL FIELD

The present invention relates to a crystalline oxide semiconductor film, a layered structure, and a semiconductor device.

BACKGROUND ART

Semiconductor devices using gallium oxide ($Ga_2O_3$) having a large band gap have been attracting attention, as next-generation switching elements which can realize high voltage resistance, low loss and high heat resistance, and are expected to be applied to a power semiconductor device such as an inverter. According to Non-Patent Document 1, the band gap of gallium oxide can be controlled by forming a mixed crystal of gallium oxide and each of or in combination with indium and aluminum. Among the mixed crystals, InAlGaO-based semiconductors are extremely attractive materials, which are represented by $In_{X1}Al_{Y1}Ga_{Z1}O_3$ ($0 \leq X1 \leq 2$, $0 \leq Y1 \leq 2$, $0 \leq Z1 \leq 2$, $X1+Y1+Z1 = 1.5$ to $2.5$).

In Patent Document 1, such a $Ga_2O_3$-based semiconductor element is described that a p-type $\alpha$-$(Al_{X2}Ga_{1-X2})_2O_3$ single crystal film ($0 \leq X2 < 1$) is formed on an $\alpha$-$Al_2O_3$ substrate. However, the semiconductor element described in Patent Document 1 has a problem in a quality of the crystal, and thus, there are many restrictions on application to a semiconductor element. In addition, it is difficult to produce the $\alpha$-$Ga_2O_3$ single crystal film (in the case of X2=0) by an MBE method; furthermore, in order to obtain a p-type semiconductor, ion implantation and heat treatment at a high temperature are required; and accordingly, it is difficult to realize a p-type $\alpha$-$Ga_2O_3$ itself. In fact, it has been difficult to realize the semiconductor element itself described in Patent Document 1.

Patent Document 2 describes a corundum- structured oxide crystal containing aluminum and gallium, and describes that phase transition at a high temperature is suppressed. However, there are still many problems in the mixed crystal having a large band gap. For example, even when the mixed crystal is used as a buffer layer, a rotational domain is present or a warp occurs in an epitaxially grown crystal, and thus, the mixed crystal has not been necessarily satisfactory.

CITATION LIST

PATENT LITERATURE

Patent Document 1: JP 2013-058637 A
Patent Document 2: JP 2015-017027 A
Patent Document 3: JP 6876895 B
Patent Document 4: JP 7016489 B
Patent Document 5: JP 7265624 B

NON PATENT LITERATURE

Non Patent Document 1: Kentaro Kaneko, "Growth and physical properties of corundum-structured gallium oxide-based mixed crystal thin film", Doctoral thesis of Kyoto University, March 2013

SUMMARY OF INVENTION

TECHNICAL PROBLEM

In particular, it is required to provide a crystalline oxide semiconductor film in which a rotational domain is reduced and crystallinity is satisfactory.

In response to this problem, examples are described in Patent Document 3 and Patent Document 4, in which the $\alpha$-$Ga_2O_3$ is formed that has a content ratio of rotational domains of less than 0.02% and a film thickness of 1 $\mu$m or larger, while containing a dopant, by forming the $\alpha$-$Ga_2O_3$ on a base body via a buffer layer having a quantum-well structure. In addition, in Patent Document 3 and Patent Document 4, examples are described in which the $\alpha$-$Ga_2O_3$ is formed in which the count number of rotational domains is 0 count with respect to 100,000 counts, while containing a dopant, by forming the $\alpha$-$Ga_2O_3$ via a buffer layer having a quantum-well structure.

However, when the present inventors have formed a film on a 4-inch (diameter of 100 mm) substrate, on the basis of Patent Document 3 and Patent Document 4 and analyzed the film in detail; and as a result, have found that the rotational domain is present at a ratio of 2 counts with respect to 500,000 counts, which is a total area of peaks of the rotational domain with respect to a total area of peaks, which are obtained by the $\phi$ scan of the X-ray diffraction measurement of a (104) plane that is an asymmetric plane. This number is 0.4 counts with respect to 100,000 counts, in other words, results in 0 count when being rounded off to the first decimal place; but the rotational domain is contained. In addition, it has been found that when the film is formed on a substrate of 6 inches (diameter of 150 mm) or larger, further more rotational domains are contained. Even in the inventions described in Patent Document 3 and Patent Document 4, the reduction of the rotational domain is insufficient, and further reduction of the rotational domain is necessary.

In addition, in Patent Document 5, an example is described in which $\alpha$-Ga$_2$O$_3$ has been formed that does not substantially contain the rotational domain over a wide range. However, when the present inventors formed films on a 4-inch (diameter of 100 mm) substrate, a 6-inch (diameter of 150 mm) substrate, and an 8-inch (diameter of 200 mm) substrate, on the basis of Patent Document 5, such many rotational domains were observed that a peak intensity obtained by the $\phi$ scan of the X-ray diffraction measurement of the (104) plane which was an asymmetric plane was a ratio of 158 counts with respect to 100,000 counts (content ratio of 0.158%). Furthermore, the peak intensity of the rotational domain increased as the distance from the center of the substrate increased, and particularly in the case of the 6-inch substrate or the 8-inch substrate, the content ratio of the rotational domain did not become uniform in the plane. In the method described in Patent Application 5, it is considered that because the film is formed by a mist which is supplied to the center of the substrate, the film becomes non-uniform as the substrate gets larger. As described above, the method described in Patent Document 5 is also insufficient to reduce the rotational domain, and a method of further reducing the rotational domain is required particularly in a large-diameter substrate.

The present invention has been made to solve the above problems, and an object of the present invention is to provide a crystalline oxide semiconductor film that has satisfactory crystallinity in which the rotational domain is more reduced, and is useful particularly for a semiconductor device.

SOLUTION TO PROBLEM

The present invention has been made to achieve the above object, and provides a crystalline oxide semiconductor film, wherein the crystalline oxide semiconductor film is a uniaxially oriented film containing $\alpha$-Ga$_2$O$_3$ as a main component, wherein a total area (C2) of peaks of a rotational domain with respect to a total area (C1) of peaks of the crystalline oxide semiconductor film, which are obtained by $\phi$ scan of X-ray diffraction measurement of an asymmetric plane of the crystalline oxide semiconductor film, is the total area (C2) of the peaks of the rotational domain being less than 5 counts with respect to 1,000,000 counts of the total area (C1) of the peaks of the crystalline oxide semiconductor film.

Such a crystalline oxide semiconductor film has more reduced rotational domains, has more reduced warps and cracks as well, has satisfactory crystallinity, and becomes useful particularly for a semiconductor device.

In the crystalline oxide semiconductor film, the total area (C2) of the peaks of the rotational domain can be 0 count, with respect to 1,000,000 counts of the total area (C1) of the peaks of the crystalline oxide semiconductor film.

Such a crystalline oxide semiconductor film has further reduced rotational domains, has further reduced warps and cracks as well, has satisfactory crystallinity, and becomes further useful particularly for a semiconductor device.

The present invention also provides a crystalline oxide semiconductor film, wherein the crystalline oxide semiconductor film is a uniaxially oriented film containing $\alpha$-Ga$_2$O$_3$ as a main component, wherein a total area (C2) of peaks of a rotational domain with respect to a total area (C1) of peaks of the crystalline oxide semiconductor film, which are obtained by $\phi$ scan of X-ray diffraction measurement of an asymmetric plane of the crystalline oxide semiconductor film, is the total area (C2) of the peaks of the rotational domain being 0 count with respect to 500,000 counts of the total area (C1) of the peaks of the crystalline oxide semiconductor film.

Such a crystalline oxide semiconductor film has more reduced rotational domains, has more reduced warps and cracks as well, has satisfactory crystallinity, and becomes useful particularly for a semiconductor device.

In this case, the crystalline oxide semiconductor film can contain a dopant.

Such a crystalline oxide semiconductor film contains the dopant, and thereby can control a flow of electrons and holes.

In addition, a thickness of the crystalline oxide semiconductor film can be 1 $\mu$m or larger.

Such a crystalline oxide semiconductor film becomes more useful for a semiconductor device.

In addition, Ga can account for 90 atom% or more of metals contained in the crystalline oxide semiconductor film.

Such a crystalline oxide semiconductor film becomes more useful for a semiconductor device.

In addition, the crystalline oxide semiconductor film can have a size with a diameter of 2 inches (50 mm) or larger. Furthermore, the crystalline oxide semiconductor film can have a size with a diameter of 6 inches (150 mm) or larger.

In such a crystalline oxide semiconductor film, the larger is the area, the more excellent is the productivity.

In addition, a half-value width of a rocking curve in a plane parallel to a principal plane of the crystalline oxide semiconductor film can be 25 arcsec or smaller, and a half-value width of a rocking curve in the asymmetric plane can be 2500 arcsec or smaller.

Such a crystalline oxide semiconductor film is excellent in the crystallinity, and becomes more useful for a semiconductor device.

In addition, the crystalline oxide semiconductor film can have a c-plane as a principal plane.

Such a crystalline oxide semiconductor film becomes more useful for a semiconductor device.

In addition, a half-value width of a rocking curve of a (006) plane of the crystalline oxide semiconductor film can be 25 arcsec or smaller.

Such a crystalline oxide semiconductor film is excellent in the crystallinity, and becomes more useful for a semiconductor device.

In addition, a half-value width of a rocking curve of a (104) plane of the crystalline oxide semiconductor film can be 2500 arcsec or smaller.

Such a crystalline oxide semiconductor film is excellent in the crystallinity, and becomes more useful for a semiconductor device.

In addition, the number of cracks of the crystalline oxide semiconductor film can be zero per $mm^2$.

Such a crystalline oxide semiconductor film becomes more useful for a semiconductor device.

In the crystalline oxide semiconductor film, a content ratio [%] of the rotational domain can be less than 0.0005%, which is calculated from a total peak area (C1) of the crystalline oxide semiconductor film and the total area (C2) of the peaks of the rotational domain, according to $C1/C2 \times 100$.

Such a crystalline oxide semiconductor film is more excellent in the crystallinity, and becomes more useful for a semiconductor device.

In the crystalline oxide semiconductor film, the content ratios of the rotational domains can be all less than 0.0005% in the measurements at five points in a plane of the crystalline oxide semiconductor film.

Such a crystalline oxide semiconductor film becomes more useful for a semiconductor device.

In the crystalline oxide semiconductor film, a coefficient of variation of the content ratios of the rotational domains can be less than 0.35, which are measured at five points in a plane of the crystalline oxide semiconductor film.

Such a crystalline oxide semiconductor film becomes further useful for a semiconductor device.

In the crystalline oxide semiconductor film, a content ratio [%] of the rotational domain can be less than 0.0002%, which is calculated from the total peak area (C1) of the crystalline oxide semiconductor film and the total area (C2) of the peaks of the rotational domain, according to $C1/C2 \times 100$.

Such a crystalline oxide semiconductor film is more excellent in the crystallinity, and becomes more useful for a semiconductor device.

In the crystalline oxide semiconductor film, the content ratios of the rotational domains can be all less than 0.0002% in the measurements at five points in a plane of the crystalline oxide semiconductor film.

Such a crystalline oxide semiconductor film becomes more useful for a semiconductor device.

In addition, the count number of peaks having the highest intensity among peaks of the rotational domain can be 0 count with respect to 150,000 counts of the count number of the peaks having the highest intensity among peaks that are obtained by ϕ scan of the X-ray diffraction measurement of the asymmetric plane of the crystalline oxide semiconductor film.

Such a crystalline oxide semiconductor film is further excellent in the crystallinity, and becomes more useful for a semiconductor device.

The present invention provides a layered structure including: a base body; and a crystalline oxide semiconductor film layered on the base body via a buffer layer, wherein the buffer layer includes Ga as a main component, and is a layered structure in which three or more buffer films are layered so that a composition ratio of Ga increases from a base body side of the buffer layer toward a crystalline oxide semiconductor film side; at least two layers of the buffer films have a film thickness of 200 nm or larger and 650 nm or smaller; the base body has a corundum structure; and the crystalline oxide semiconductor film is the crystalline oxide semiconductor film of the present invention.

Such a layered structure has a more reduced rotational domain of the crystalline oxide semiconductor film, has more reduced warps and cracks as well, has satisfactory crystallinity, and becomes useful particularly for a semiconductor device.

In the layered structure, a film thickness of all of the buffer films in the buffer layer can be 200 nm or larger and 650 nm or smaller.

Such a buffer layer can suppress the introduction of the warp and a defect.

In addition, the buffer layer can include Al, and be a layered structure in which three or more buffer films are layered so that a composition ratio of Al decreases from the base body side of the buffer layer toward the crystalline oxide semiconductor film side.

Such a buffer layer can be used to provide a crystalline oxide semiconductor film in which a stress due to a difference in lattice constant is alleviated, the warp, the crack and the rotational domain are suppressed, and has a small in-plane distribution of the film thickness, at an excellent film forming rate.

The present invention provides a semiconductor device that includes at least one of the crystalline oxide semiconductor film of the present invention and the layered structure of the present invention.

Such a semiconductor device can result in satisfactory device characteristics, because the crystalline oxide semiconductor film of the present invention is used, in which the rotational domain is more reduced and the crystallinity is satisfactory.

In this case, the semiconductor device can be any one of a semiconductor laser, a diode and a transistor.

Such a semiconductor device can provide a semiconductor laser, a diode or a transistor, which has satisfactory device characteristics.

ADVANTAGEOUS EFFECTS OF INVENTION

The crystalline oxide semiconductor film of the present invention can provide a crystalline oxide semiconductor film that has a more reduced rotational domain, has satisfactory crystallinity, and is useful particularly for a semiconductor device.

BRIEF DESCRIPTION OF DRAWINGS

FIG. 1 is a typical example of $\phi$ scan of an asymmetric plane ((104) plane) of a crystalline oxide semiconductor film according to the present invention, and is a figure showing a result of Example 1;
FIG. 2 is a view showing one embodiment of a structure of a layered structure according to the present invention;
FIG. 3 is a view showing another embodiment of the structure of the layered structure according to the present invention;
FIG. 4 is a view showing an example of a Schottky barrier diode according to the present invention;
FIG. 5 is a view showing an example of a high electron mobility transistor according to the present invention;
FIG. 6 is a view showing an example of a semiconductor field-effect transistor according to the present invention;
FIG. 7 is a view showing an example of an insulated gate bipolar transistor according to the present invention;
FIG. 8 is a view showing an example of a light-emitting element diode according to the present invention;
FIG. 9 is a view showing an example of a film forming apparatus according to the present invention;
FIG. 10 is a view showing another example of the film forming apparatus according to the present invention;
FIG. 11 is a view showing an example of a misting unit according to the present invention;
FIG. 12 is a view showing an example of the film forming apparatus according to the present invention;
FIG. 13 is a view showing another example of the film forming apparatus according to the present invention;
FIG. 14 is a diagram showing a measurement point according to the present invention; and
FIG. 15 is a figure showing a result of $\phi$ scan of a (104) plane in Comparative Example 1.

DESCRIPTION OF EMBODIMENTS

The present invention will be described in detail below, but the present invention is not limited thereto.

As described above, the crystalline oxide semiconductor film has been required in which a rotational domain is more reduced and crystallinity is satisfactory.

The present inventor has conducted intensive studies on the above problems; and as a result, has succeeded in creation of a crystalline oxide semiconductor film, wherein the crystalline oxide semiconductor film is a uniaxially oriented film containing $\alpha$-$Ga_2O_3$ as a main component, wherein a total area (C2) of peaks of a rotational domain with respect to a total area (C1) of peaks of the crystalline oxide semiconductor film, which are obtained by $\phi$ scan of X-ray diffraction measurement of an asymmetric plane of the crystalline oxide semiconductor film, is the total area (C2) of the peaks of the rotational domain being less than 5 counts with respect to 1,000,000 counts of the total area (C1) of the peaks of the crystalline oxide semiconductor film; has found that such a crystalline oxide semiconductor film more reduces not only the rotational domain but also the warp and the crack, and can solve the conventional problems at once: and has completed the present invention.

The present inventor also has succeeded in creation of a crystalline oxide semiconductor film, wherein the crystalline oxide semiconductor film is a uniaxially oriented film containing $\alpha$-$Ga_2O_3$ as a main component, wherein a total area (C2) of peaks of a rotational domain with respect to a total area (C1) of peaks of the crystalline oxide semiconductor film, which are obtained by $\phi$ scan of X-ray diffraction measurement of an asymmetric plane of the crystalline oxide semiconductor film, is the total area (C2) of the peaks of the rotational domain being 0 count with respect to 500,000 counts of the total area (C1) of the peaks of the crystalline oxide semiconductor film; has found that such a crystalline oxide semiconductor film more reduces not only the rotational domain but also the warp and the crack, and can solve the conventional problems at once: and has completed the present invention.

Details thereof will be described below with reference to the drawings and the tables.

The crystalline oxide semiconductor film of the present invention is a crystalline oxide semiconductor film, wherein the crystalline oxide semiconductor film is the uniaxially oriented film containing the $\alpha$-$Ga_2O_3$ as the main component, wherein the total area (C2) of the peaks of the rotational domain with respect to the total area (C1) of the peaks of the crystalline oxide semiconductor film, which are obtained by the $\phi$ scan of the X-ray diffraction measurement of the asymmetric plane of the crystalline oxide semiconductor film, is the total area (C2) of the peaks of the rotational domain being less than 5 counts with respect to 1,000,000 counts of the total area (C1) of the peaks of the crystalline oxide semiconductor film.

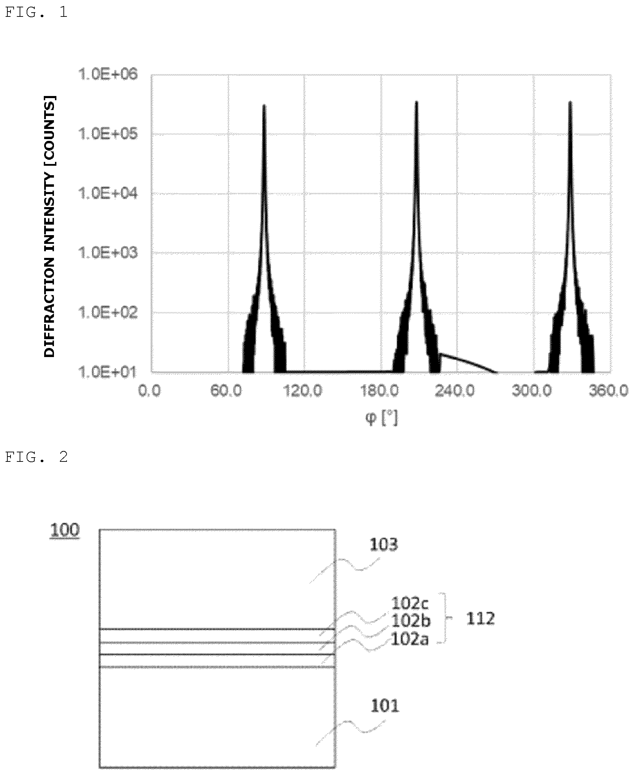

In addition, the crystalline oxide semiconductor film of the present invention is a crystalline oxide semiconductor film, wherein the crystalline oxide semiconductor film is the uniaxially oriented film containing the $\alpha$-$Ga_2O_3$ as the main component, wherein the total area (C2) of the peaks of the rotational domain with respect to the total area (C1) of the peaks of the crystalline oxide semiconductor film, which are obtained by the $\phi$ scan of the X-ray diffraction measurement of the asymmetric plane of the crystalline oxide semiconductor film, is the total area (C2) of the peaks of the rotational domain being 0 count with respect to 500,000 counts of the total area (C1) of the peaks of the crystalline oxide semiconductor film. FIG. 1 shows a typical example of the $\phi$ scan measurement of the present invention, but details thereof will be described later.

The crystalline oxide semiconductor film is the uniaxially oriented film containing the $\alpha$-$Ga_2O_3$ as the main component, and is more preferably a single crystal. In addition, the $\alpha$-$Ga_2O_3$ is a metal oxide having a corundum structure, and has trigonal symmetry. The term "main component" as used herein means that the $\alpha$-$Ga_2O_3$ accounts for 50 to 100 mol% of the crystalline oxide semiconductor film. In the present application, among metal components of the crystalline oxide semiconductor film, Ga may account for 50 atom% or more, preferably accounts for 90 atom% or more, and more preferably accounts for 95 atom% or more. Oxides other than the $\alpha$-$Ga_2O_3$ are not particularly limited as long as the oxides are metal oxides which can form the corundum structure; and can be, for example, an oxide containing any of aluminum, titanium, vanadium, chromium, iron, gallium, rhodium, indium and iridium.

The uniaxially oriented film as used herein refers to a film in which a peak is observed only in a specific plane orientation in the X-ray diffraction measurement of the principal plane of the crystalline oxide semiconductor film. For example, in the case where the c-plane is the principal plane, the film is a film in which the peak of only a part of a plane parallel to a (006) plane is observed.

The total area (C1) of the peaks of the crystalline oxide semiconductor film and the total area (C2) of the peaks of the rotational domain are measured with the use of the X-ray diffraction measurement apparatus, and more specifically, can be measured by performing the $\phi$ scan of the asymmetric plane with the use of the X-ray diffraction measurement apparatus. The asymmetric plane refers to a plane inclined with respect to the principal plane of the crystalline oxide semiconductor film. More specifically, the asymmetric plane includes the (104) plane when the c-plane is the principal plane, a (300) plane when an a-plane is the principal plane, the (006) plane when an r-plane is the principal plane, the (104) plane when an m-plane is the principal plane, and a (110) plane when an n-plane is the principal plane, respectively.

The $\phi$ scan is a method of performing measurement by using an X-ray diffraction measurement apparatus, fixing angles of $2\theta$, $\omega$ and $\chi$, and rotating a $\phi$-axis parallel to the normal line of the principal plane of a sample, from 0° to 360°. For example, an angle formed by the asymmetric plane and the sample surface is calculated from an inner product of reciprocal lattice vector, and the $\chi$-axis is inclined so that the direction of the scattering vector formed by the X-ray incident light and the X-ray diffracted light matches the direction of the reciprocal lattice vector of the asymmetric plane. After that, $2\theta/\omega$ scan is performed in a state in which the $\chi$-axis is inclined, and the respective angles are fixed to $2\theta$ and $\omega$ at which diffraction peaks of an asymmetric plane are obtained. Subsequently, the $\phi$-axis is rotated and scanning is performed in a state where $\chi$, $2\theta$ and $\omega$ are fixed, and thereby peaks are obtained.

In the $\phi$ scan of the asymmetric plane, peaks appear at angular intervals corresponding to the symmetry of the asymmetric plane with respect to the $\phi$-axis. For example, in the case where the (104) plane which is the asymmetric plane is measured on a sample of which the principal plane is the c-plane, the (104) plane is three-fold symmetric with respect to the $\phi$-axis, and accordingly, three peaks are observed at intervals of 120°.

The total area (C2) of the peaks of the rotational domain with respect to the total area (C1) of the peaks of the crystalline oxide semiconductor film, which are obtained by the $\phi$ scan, is the total area (C2) of the peaks of the rotational domain being less than 5 counts with respect to 1,000,000 counts of the total area (C1) of the peaks of the crystalline oxide semiconductor film.

In addition, the total area (C2) of the peaks of the rotational domain with respect to the total area (C1) of the peaks of the crystalline oxide semiconductor film, which are obtained by the $\phi$ scan, is the total area (C2) of the peaks of the rotational domain being 0 count with respect to 500,000 counts of the total area (C1) of the peaks of the crystalline oxide semiconductor film.

As a typical example of the $\phi$ scan of the asymmetric plane ((104) plane) of the crystalline oxide semiconductor film according to the present invention is shown in FIG. 1, the $\phi$ scan of the (104) plane is performed by rotating the $\phi$-axis parallel to the normal line of the sample surface while fixing $2\theta$ and $\omega$ at the position at which the peak has been obtained, and the result can be obtained. The total area (C2) of the peaks of the rotational domain is preferably 0 count even with respect to 1,000,000 counts of the total area (C1) of the peaks of the crystalline oxide semiconductor film, and the total area (C2) of the peaks of the rotational domain is more preferably 0 count even with respect to 3,000,000 counts of the total area (C1) of the peaks of the crystalline oxide semiconductor film. Such a crystalline oxide semiconductor film results in excellent characteristics when used in a semiconductor device.

The total area (C1) of the peaks of the crystalline oxide semiconductor film and the total area (C2) of the peaks of the rotational domain used here can be calculated by integrating the count numbers of the peaks at each angle in the X-ray diffraction measurement. For example, when the peak A appears at $\phi$ = 90.00 to 90.10° and the step width of the $\phi$-axis is 0.02°, the area of the peak A can be calculated by integrating the count numbers of 90.00°, 90.02°, 90.04°, 90.06°, 90.08° and 90.10°.

Here, a content ratio of the rotational domain is calculated with the use of the total area (C1) of the peaks of the crystalline oxide semiconductor film and the total area (C2) of the peaks of the rotational domain in the $\phi$ scan, according to (content ratio of rotational domain [%]) = C2/C1 × 100. For example, when the total area of the peaks of the crystalline oxide semiconductor film is 100,000 counts, and the total peak area of the rotational domains is 5 counts, the content ratio of the rotational domains becomes 0.005%. The content ratio of the rotational domain is suitably less than 0.0005%, preferably less than 0.0002%, and more preferably less than 0.0001%, and further preferably 0%.

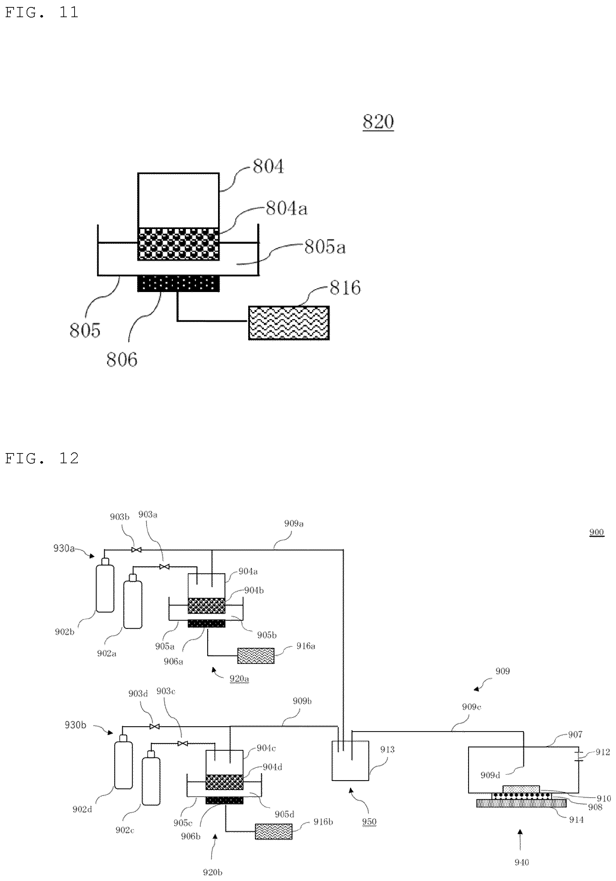

In addition, it is acceptable for the content ratio of the rotational domain to be all less than 0.0005% in the measurements of the five points in the plane of the crystalline oxide semiconductor film, is preferably less than 0.0002%, more preferably less than 0.0001%, and further preferably 0%. In the case, for example, where a shape of the crystalline oxide semiconductor film is circular, the measurement point can be set in a polar coordinate system as in FIG. 11, in which a radius of a substrate is R, the center of the substrate is the origin 0, a distance from the origin 0 is r, and an angle formed with the x-axis is $\theta$ [°], so as to be (r, $\theta$) = (0, 0), (0.5R, 0), (0.5R, 90), (0.5R, 180) and (0.5R, 270). In the case where a shape of the crystalline oxide semiconductor film is quadrangular, it is acceptable to set five points in total, which are one point at the center and four points at the midpoints of straight lines which connect the center and the midpoints of the sides.

In addition, the coefficient of variation of the content ratios of the rotational domains which have been measured at five points in the plane is suitably smaller than 0.35, and preferably 0.25 or smaller. Such a crystalline oxide semiconductor film becomes further useful for a semiconductor device. The coefficient of variation can be calculated from the following expression.

$$Cv = \frac{\sqrt{\frac{1}{n}\sum_{i=1}^{n}(x_i - \bar{x})^2}}{\bar{x}}$$

where, $Cv$ : **coefficient of variation,** $x_i$ : **each data,** $\bar{x}$ : **average value,** $n$ : **number of data.**

In addition, at this time, it is acceptable that the count number (peak height) of the peak having the highest intensity among the peaks of the rotational domain is 0 count with respect to 150,000 counts of the count number (peak height) of the peak having the highest intensity among the peaks obtained by the $\phi$ scan of the X-ray diffraction measurement of the asymmetric plane of the crystalline oxide semiconductor film, and is more preferably 0 count even with respect to 300,000 counts.

It is preferable that the crystalline oxide semiconductor film has the c-plane as the principal plane. Thereby, the crystalline oxide semiconductor film becomes more suitable for a semiconductor device. In addition, a half-value width of a rocking curve which is obtained by $\omega$ scan of X-ray diffraction measurement of a plane (for example, (006) plane in the case where the c-plane is the principal plane) parallel to the principal plane of the crystalline oxide semiconductor film is suitably 25 arcsec or smaller, preferably 16 arcsec or smaller, and more preferably 10 arcsec or smaller. The smaller the half-value width is, the more excellent the crystallinity is and the device characteristics become excellent.

In addition, the half-value width of the rocking curve, which is obtained by the $\omega$ scan of the X-ray diffraction measurement of the asymmetric plane (for example, the (104) plane when the c-plane is the principal plane) of the crystalline oxide semiconductor film is suitably 2500 arcsec or smaller, preferably 2000 arcsec or smaller, and more preferably 1500 arcsec or smaller. The smaller the half-value width is, the excellent the crystallinity is, and when the crystalline oxide semiconductor film is used particularly for a semiconductor device or the like, the device characteristics become excellent.

In addition, a thickness of the crystalline oxide semiconductor film is not particularly limited. In the present invention, the thickness is suitably 1 $\mu$m or larger, preferably 2 $\mu$m or larger, and more preferably 3$\mu$m or larger. Thereby, the crystalline oxide semiconductor film becomes more suitable for a semiconductor device. The upper limit of the thickness is not particularly limited, but can be 1000 $\mu$m or smaller, 500 $\mu$m or smaller, or 100 $\mu$m or smaller, for example.

In addition, in the present invention, the warp of the crystalline oxide semiconductor film is preferably 0.21 $\mu$m or

smaller, and is preferably 0.17 μm or smaller. The term "warp" refers to the shortest distance between the shortest straight line passing through points of both ends of the film (for example, both ends between the 5 mm portions) and the apex of the concave or convex portion. In the present invention, for example, when the shortest distance between the shortest straight line passing through the points of both ends between the 5 mm portions of the film and the apex of the concave or convex portion is defined as the warp, the warp is preferably smaller than 0.042 μm/mm.

A dopant may be contained in the oxide semiconductor film. By containing the dopant, the oxide semiconductor film becomes capable of controlling a flow of electrons and holes. The dopant is not particularly limited. Examples of the dopant include: n-type dopants such as tin, germanium, silicon, titanium, zirconium, vanadium and niobium; and p-type dopants such as copper, silver, tin, cobalt, iridium and rhodium. A concentration of the dopant may be controlled, for example, to about $1.0 \times 10^{16}$ to $1.0 \times 10^{22}$ /cm$^3$; and also, may be controlled to a low concentration of about $1.0 \times 10^{17}$ /cm$^3$ or lower, or to a high concentration of about $1.0 \times 10^{20}$ /cm$^3$ or higher.

An area of the crystalline oxide semiconductor film is preferably larger than an area corresponding to a diameter of 2 inches (50 mm), more preferably a diameter of 4 inches (100 mm) or larger, and further preferably a diameter of 6 inches (150 mm) or larger. The upper limit of the area is not particularly limited, and the larger the area is, the more excellent the productivity is. For example, the area can be an area corresponding to a diameter of 12 inches (300 mm), or smaller.

In addition, in the present invention, it is preferable that the number of cracks per 1 mm$^2$ be 0 in the crystalline oxide semiconductor film, in other words, that the crack not be included. A method for evaluating the number of cracks is not particularly limited. It is possible to obtain the converted number of cracks per 1 mm$^2$, by checking the number of cracks on the whole surface of the crystalline oxide semiconductor film by an optical surface inspection device, and dividing the number of cracks by the inspection area. Alternatively, it is acceptable to count the number of cracks by observation of the 1 mm$^2$ portion, with the use of a SEM, a TEM, an optical microscope or the like.

The crystalline oxide semiconductor film according to the present invention can be used for a semiconductor device through appropriate design of the structure. Examples of the semiconductor device will be described in detail later.

(Method for producing crystalline oxide semiconductor film)

It is possible to obtain the crystalline oxide semiconductor film according to the present invention, by appropriately selecting a base body and a buffer layer, and then, forming the film, as will be described later. The method for forming the film is not particularly limited, and can be realized by a wide variety of known methods such as plasma CVD, LPCVD (low pressure CVD), APCVD (atmospheric pressure CVD), mist CVD, HVPE, sputtering and ion plating; but the film is preferably formed with the use of the mist CVD method. The method for forming the film with the use of the mist CVD method will be described in detail later.

(Layered structure)

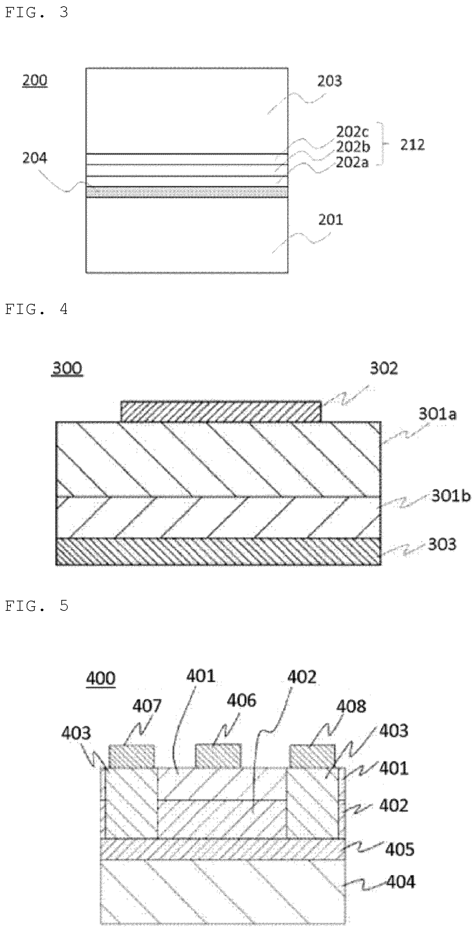

FIG. 2 and FIG. 3 are views each showing an embodiment of the structure of the layered structure according to the present invention. The layered structures 100 and 200 each having the crystalline oxide semiconductor film according to the present invention basically include base bodies 101 and 201, buffer layers 112 and 212, and crystalline oxide semiconductor films 103 and 203, respectively, and are constituted by the buffer layers 112 and 212 formed on principal surfaces of the base bodies 101 and 201, and the crystalline oxide semiconductor films 103 and 203 formed thereon, respectively.

(Base body)

The base bodies 101 and 201 are not particularly limited as long as the base bodies each contain a crystal as a main component, and each may be a known substrate. The base body may be an insulator, a conductor, a semiconductor, a single crystal or a polycrystal. Examples of the material include: polysulfone, poly(ethersulfone), polyphenylene sulfide, polyether ether ketone, polyimide, polyetherimide and fluorine resins; metals such as iron, aluminum, stainless steel and gold; and silicon, sapphire, quartz, glass, gallium oxide, lithium niobate and lithium tantalate; but are not limited to these substances. In particular, a substance having a corundum structure is preferable.

In addition, a base body is preferably used in which a main component metal element contained in the largest amount is aluminum among the metal elements contained in the base body. Among the base bodies, a sapphire wafer is preferably used from the viewpoint of a quality and a cost.

The plane orientation of the principal plane of the base body is not particularly limited, and in the case of the sapphire wafer, for example, a plane such as a c-plane, an m-plane, an a-plane, an r-plane, or an n-plane can be used. In addition, the plane may have an off-angle with respect to the just plane. The off-angle is not particularly limited, but is preferably 0 to 15°.

The thicknesses of the base bodies 101 and 201 are not particularly limited, but are each preferably about 200 to 800 µm from the viewpoint of the cost. In addition, each of the areas of the principal surfaces of the base bodies 101 and 201 is suitably 10 cm$^2$ or larger, is preferably larger than an area corresponding to a diameter of about 5 cm (2 inches), more preferably a diameter of about 10 cm (4 inches) or larger, and further preferably a diameter of about 15 cm (6 inches) or larger. When the diameters of the base bodies 101 and 201 are each controlled to be large as in the above, the crystalline oxide semiconductor films 103 and 203 formed on the base bodies 101 and 201 result in each having a higher quality and a higher productivity; and in addition, having a higher degree of freedom of device design. The upper limit of the area is not particularly limited, and the larger the area is, the more excellent the productivity is. For example, the area can be an area corresponding to 12 inches (300 mm) in diameter, or smaller. The shapes of the base bodies 101 and 201 are not particularly limited in the present invention. The shape may be a circle or a quadrangle such as a square.

(Buffer layer)

In addition, in the layered structure according to the present invention, the buffer layer includes Ga as a main component, and is a layered structure in which three or more buffer films are layered so that a composition ratio of Ga increases from a base body side of the buffer layer toward a crystalline oxide semiconductor film side; and the film thickness of at least two buffer films of the buffer films is 200 nm or larger and 650 nm or smaller. The buffer layer is preferably an oxide semiconductor having a corundum structure.

The buffer layer may be formed directly on the base body 101 such as the buffer layer 112 in FIG. 2, or may be formed via another layer. In the case, for example, where a separation layer for separating the crystalline oxide semiconductor film from the base body is introduced as another layer, the buffer layer may be formed on a separation layer 204, as in the case of the buffer layer 212 in FIG. 3.

The buffer layer 112 becomes a layered structure of a plurality of buffer films 102a, 102b and 102c each having a different composition; and the buffer layer 212 is also a layered structure of a plurality of buffer films 202a, 202b and 202c each having the different composition. The respective buffer films of 102a, 102b and 102c or 202a, 202b and 202c of the buffer layers 112 and 212 shall have different compositions. In addition, in the buffer layer, Ga is contained which is the main component metal element contained in the largest amount among the metal elements contained in the above described crystalline oxide semiconductor films 103 and 203. At this time, it is more acceptable that the buffer film contains a main component metal element contained in the largest amount among metal elements contained in the underlayer of the buffer layer. Here, the main component metal element of the underlayer of the buffer layer refers to the main component metal element of the base body 101 in the embodiment of FIG. 2, and refers to the main component metal element of the separation layer 204 in the embodiment of FIG. 3. The "main component" as used herein refers to a component that accounts for 50 to 100 atom% of the metal components.

In the present invention, the buffer layer includes Ga as the main component, and may be formed of three or more buffer films so that a composition ratio of Ga increases from the base body side of the buffer layer toward the crystalline oxide semiconductor film side; and the number of layers and the composition of the whole buffer film can be appropriately adjusted depending on conditions such as the thickness of the crystalline oxide semiconductor film. At this time, the thickness of each of the buffer films of at least two layers among the three or more buffer films is controlled to a film thickness of 200 nm or larger and 650 nm or smaller. The thicknesses of the at least two buffer films may be the same or different, but if the thickness is smaller than 200 nm, a sufficient effect cannot be obtained, and if the thickness is larger than 650 nm, stresses become remarkable and the warp and the defect become to be introduced. It is more preferable that all the film thicknesses of the three or more buffer films be 200 nm or larger and 650 nm or smaller.

In addition, it is acceptable that the buffer layer of three or more layers includes Ga as a main component, and is layered so that the composition ratio of Ga increases from the base body side of the buffer layer toward the crystalline oxide semiconductor film side. For example, in the embodiment of FIG. 2, the composition ratio of Ga increases in the order of the buffer film 102a, 102b and 102c.

In the case where the buffer film contains the main component metal element of the underlayer of the buffer layer, it is acceptable that the buffer film is layered so that the composition ratio of the main component metal element of the underlayer of the buffer layer decreases from the base body side toward the crystalline oxide semiconductor film side. For example, when a crystalline oxide semiconductor film of $\alpha$-Ga$_2$O$_3$ is formed on an Al$_2$O$_3$ wafer, it is acceptable to form the buffer film from (Al$_x$Ga$_{1-x}$)$_2$O$_3$ (0<x<1), and decrease a value of x from the base body (wafer) side toward the crystalline oxide semiconductor film side. Due to the film formation of the crystalline oxide semiconductor film on the buffer layer of which the composition is monotonously changed in this way, the stress due to the difference in lattice constant is alleviated, and the warp, the crack and the rotational domain are suppressed, and the crystalline oxide semiconductor film in which the in-plane distribution of the film thickness is small can be obtained at an excellent film forming rate.

The composition of the buffer layer can be controlled by changing a ratio of a supply amount of each metal raw material. For example, in the case where the mist CVD method is employed, the composition of the buffer layer can be controlled by changing the concentration of the raw material solution, a flow rate of a carrier gas for transporting mist, and the film forming temperature.

In addition, a base body is preferably used in which the main component metal element contained in the largest amount is aluminum among the metal elements contained in the base body, and to use the underlayer of the buffer layer as the base body. The embodiment is advantageous in terms of the quality and the cost.

(Method for producing layered structure)

The method for producing the layered structure according to the present invention is not particularly limited. It is possible to obtain the layered structure, by appropriately selecting the base body and the buffer layer, according to the type of the crystalline oxide semiconductor film, and the semiconductor element to be applied, and forming the film on the base body. The method for forming the film is not particularly limited, and can be realized by a wide variety of known methods such as plasma CVD, LPCVD (low pressure CVD), APCVD (atmospheric pressure CVD), mist CVD, HVPE, sputtering and ion plating; but the film is preferably used with the use of the mist CVD method. The method for forming the film with the use of the mist CVD method will be described in detail later. In addition, means for forming the buffer layer (buffer film) is not particularly limited. Such means is preferable as to produce a film by growing a crystal on a base body with the use of mist.

(Semiconductor device)

In addition, a semiconductor device according to the present invention includes at least one of the above described crystalline oxide semiconductor film and the above described layered structure. For example, a semiconductor device (semiconductor element) such as a semiconductor laser, a diode or a transistor can be provided. Such a semiconductor device may include a base body or may have the base body removed. The semiconductor device according to the present invention uses a high-quality crystalline oxide semiconductor film with satisfactory crystallinity and is a high-quality semiconductor device. Application examples (specific examples) of the semiconductor device are as follows.

(Examples of applicable semiconductor device)

The crystalline oxide semiconductor film and the layered structure having the crystalline oxide semiconductor film as in the above have satisfactory crystallinity, are excellent in electrical characteristics, and are industrially useful. Such a crystalline oxide semiconductor film and a layered structure having the crystalline oxide semiconductor film can be suitably used for various semiconductor devices and the like, and are useful particularly for a power device.

In addition, semiconductor devices can be classified into a horizontal element (horizontal device) in which an electrode is formed on one surface side of a crystalline oxide semiconductor film, and a vertical element (vertical device) which has electrodes formed on both sides of front and back faces of the crystalline oxide semiconductor film. The semiconductor device of the present invention can be suitably used for both the horizontal device and the vertical device, but is preferably used for the vertical device. Examples of the semiconductor device include a Schottky barrier diode (SBD), a metal-semiconductor field-effect transistor (MESFET), a high electron mobility transistor (HEMT), a semiconductor field-effect transistor (MOSFET), a junction field-effect transistor (JFET), an insulated gate bipolar transistor (IGBT), and a light-emitting diode (LED).

(Method for manufacturing semiconductor device)

Firstly, a buffer layer is formed on a principal surface of a base body directly or via another layer. The buffer layer contains Ga as a main component, is formed of three or more buffer films so that a composition ratio of Ga increases from a base body side of the buffer layer toward a crystalline oxide semiconductor film side, and also is formed so as to include two or more buffer films having a thickness of 200 nm or larger and 650 nm or smaller. It is preferable that all of the plurality of buffer films constituting the buffer layer be formed so as to have a thickness of 200 nm or larger and 650 nm or smaller. A layered structure according to the present invention is obtained by forming a crystalline oxide semiconductor film containing $\alpha$-$Ga_2O_3$ as a main component, on the buffer layer. After that, an electrode and the like are formed on the crystalline oxide semiconductor film, and thereby, a semiconductor device is manufactured. At this time, it is possible to use the layered structure including the base body, the buffer layer and the crystalline oxide semiconductor film, as it is; or alternatively, it is acceptable to remove the base body and leave the buffer layer and the crystalline oxide semiconductor film, or to remove the base body and the buffer layer and leave only the crystalline oxide semiconductor film. In this way, it is possible to manufacture a high-performance semiconductor device that uses a crystalline oxide semiconductor film having satisfactory crystallinity and a high quality.

Hereinafter, preferred examples of the case where the crystalline oxide semiconductor film of the present invention is applied to an n-type semiconductor layer (n+-type semiconductor, n- semiconductor layer, or the like) will be described with reference to the drawings, but the present invention is not limited to these examples. In the semiconductor elements exemplified below, further another layer (for example, an insulator layer or a conductor layer) or the like may be included, and an intermediate layer, a buffer layer (buffer layer) or the like may be omitted as appropriate.

FIG. 4 shows an example of an SBD according to the present invention. The SBD300 includes an n--type semiconductor layer 301a doped at a relatively low concentration, an n+-type semiconductor layer 301b doped at a relatively high concentration, a Schottky electrode 302, and an ohmic electrode 303.

Materials of the Schottky electrode 302 and the ohmic electrode 303 may be known electrode materials. Examples of the electrode materials include: metals such as aluminum, molybdenum, cobalt, zirconium, tin, niobium, iron, chromium, tantalum, titanium, gold, platinum, vanadium, manganese, nickel, copper, hafnium, tungsten, iridium, zinc, indium, palladium, neodymium and silver, and alloys thereof; electroconductive films of metal oxides such as tin oxide, zinc oxide, rhenium oxide, indium oxide, indium tin oxide (ITO), and indium zinc oxide (IZO); organic electroconductive compounds such as polyaniline, polythiophene and polypyrrole, and mixtures of these compounds; and layered products thereof.

The Schottky electrode 302 and the ohmic electrode 303 can be formed by known means such as a vacuum deposition method or a sputtering method, for example. More specifically, for example, in the case where the Schottky electrode is formed with the use of two types of metals, in other words, a first metal and a second metal among the above metals, the Schottky electrode can be formed by layering a layer formed of the first metal and a layer formed of the second metal, and patterning the layer formed of the first metal and the layer formed of the second metal, with the use of means of a photolithography method.

When a reverse bias is applied to the SBD 300, a depletion layer (not shown) spreads in the n--type semiconductor layer 301a, and accordingly, the SBD obtains high voltage resistance. In addition, when a forward bias is applied, electrons flow from the ohmic electrode 303 to the Schottky electrode 302. Accordingly, the SBD of the present invention is excellent for use in high voltage resistance and large current, has a high switching speed, and is excellent also in the voltage resistance and reliability.

FIG. 5 shows an example of a HEMT according to the present invention. The HEMT 400 includes an n-type semiconductor layer 401 having a wide band gap, an n-type semiconductor layer 402 having a narrow band gap, an n+-type semiconductor layer 403, a semi-insulator layer 404, a buffer layer 405, a gate electrode 406, a source electrode 407, and a drain electrode 408.

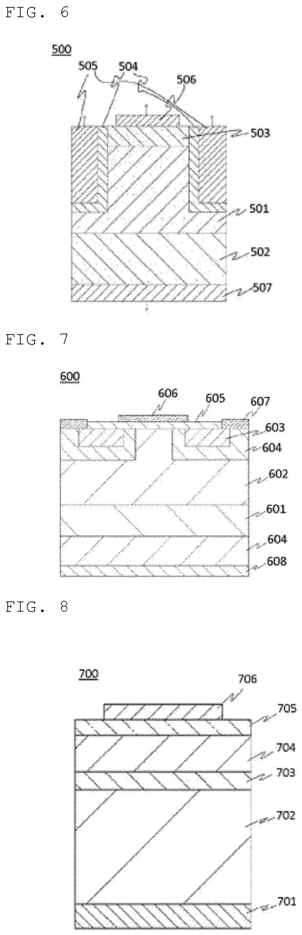

FIG. 6 shows an example of a MOSFET according to the present invention. The MOSFET 500 includes an n--type semiconductor layer 501, n+-type semiconductor layers 502 and 503, a gate insulating film 504, a gate electrode 505, a source electrode 506, and a drain electrode 507.

FIG. 7 shows an example of an IGBT according to the present invention. The IGBT 600 includes an n-type semiconductor layer 601, an n--type semiconductor layer 602, an n+-type semiconductor layer 603, a p-type semiconductor layer 604, a gate insulating film 605, a gate electrode 606, an emitter electrode 607, and a collector electrode 608.

FIG. 8 shows an example of an LED according to the present invention. The LED 700 includes a first electrode 701, an n-type semiconductor layer 702, a light-emitting layer 703, a p-type semiconductor layer 704, a translucent electrode 705, and a second electrode 706. Examples of a material of the translucent electrode include an electroconductive material of an oxide containing indium or titanium. More specific examples thereof include $In_2O_3$, $ZnO$, $SnO_2$, $Ga_2O_3$, $TiO_2$, $CeO_2$, a mixed crystal of two or more thereof, and materials obtained by doping these materials. The translucent electrode can be formed by providing these materials by known means such as sputtering. In addition, it is acceptable to subject the translucent electrode after the translucent electrode has been formed to thermal annealing, for the purpose of making the translucent electrode transparent.

Examples of materials of the first electrode 701 and the second electrode 706 include: metals such as aluminum, molybdenum, cobalt, zirconium, tin, niobium, iron, chromium, tantalum, titanium, gold, platinum, vanadium, manganese, nickel, copper, hafnium, tungsten, iridium, zinc, indium, palladium, neodymium and silver, and alloys thereof; electroconductive films of metal oxides such as tin oxide, zinc oxide, rhenium oxide, indium oxide, indium tin oxide (ITO), and indium zinc oxide (IZO); and organic electroconductive compounds such as polyaniline, polythiophene and polypyrrole, and mixtures of these compounds. The film forming method of the electrode is not particularly limited, and the electrode can be formed on the above substrate according to a method appropriately selected from wet methods such as a printing method, a spraying method and a coating method, physical methods such as a vacuum deposition method, a sputtering method and an ion plating method, chemical methods such as CVD and a plasma CVD method, and the like, in consideration of suitability for the above material.

(Film forming apparatus)

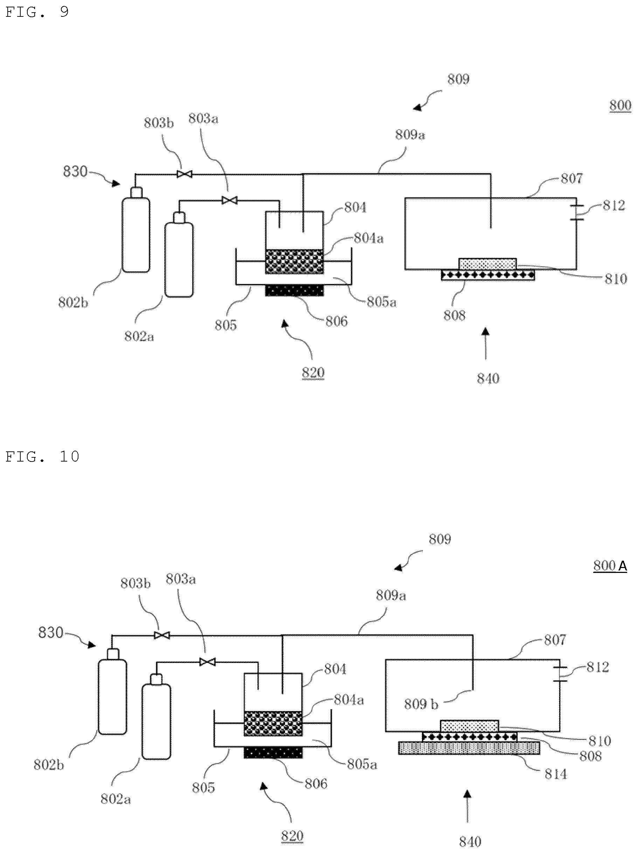

FIG. 9 shows an example of a film forming apparatus 800 which can be used for a method for forming the crystalline oxide semiconductor film or the like according to the present invention. The film forming apparatus 800 includes a misting unit 820 that generates mist by misting a raw material solution, a carrier gas supply unit 830 that supplies a carrier gas for transporting the mist, a film forming unit 840 that forms a film on a substrate by heat-treating the mist, and a transport unit 809 that connects the misting unit 820 and the film forming unit 840, and transports the mist by the carrier gas. In addition, the operation of the film forming apparatus 800 may be controlled by providing a controlling unit (not shown) that controls the whole or a part of the film forming apparatus 800.

(Misting unit)

The misting unit 820 generates mist by misting the raw material solution. Misting means is not particularly limited as long as the means can mist the raw material solution, and may be known misting means, and misting means by ultrasonic vibration is preferably used. This is because the mist can be more stably formed.

An example of such a misting unit 820 is shown in FIG. 11. The misting unit 820 may include, for example, a mist generating source 804 in which a raw material solution 804a is accommodated, a vessel 805 in which a medium that can transmit ultrasonic vibration, for example, water 805a is contained, and an ultrasonic vibrator 806 which is attached to the bottom surface of the vessel 805. Specifically, the mist generating source 804 that is formed of a vessel in which the raw material solution 804a is accommodated is accommodated in the vessel 805 in which the water 805a is accommodated, with the use of a support (not shown). The ultrasonic vibrator 806 is provided at the bottom of the vessel 805, and the ultrasonic vibrator 806 and an oscillator 816 are connected to each other. In addition, the misting unit 820 is configured so that when the oscillator 816 is operated, the ultrasonic vibrator 806 vibrates, ultrasonic waves are propagated into the mist generating source 804 through the water 805a, and the raw material solution 804a is misted.

When the buffer film is formed, it is acceptable to accommodate the raw material solution 804a in which each metallic raw material solution is mixed in the mist generating source 804 of one misting unit 820, and mist the solution; or to provide a plurality of misting units such as misting units 920a and 920b shown in FIG. 11, accommodate the metallic raw material solutions in the respectively different mist generating sources 904a and 904c of the misting units, and mist each of the metallic raw material solutions. In the case where a plurality of misting units have been provided, it is acceptable to provide a mist mixer 913 for mixing each of the raw material solutions which have been misted as shown in FIG. 11, or is acceptable to separately supply mist to a film forming chamber 907 without providing the mist mixer 913 (not shown).

(Carrier gas supply unit)

The carrier gas supply unit 830 includes a carrier gas source 802a that supplies the carrier gas, and may include a flow-rate adjusting valve 803a that adjusts a flow rate of the carrier gas sent out from the carrier gas source 802a. In addition, it is also possible to include a carrier gas source 802b for dilution for supplying a carrier gas for dilution, and a flow-rate adjusting valve 803b for adjusting a flow rate of the carrier gas for dilution, which is sent out from the carrier gas source 802b for dilution, as needed.

A type of the carrier gas is not particularly limited, and can be appropriately selected according to the film to be formed. Examples of the gas include: oxygen; ozone; inert gases such as nitrogen and argon; and reducing gases such as hydrogen gas and forming gas. In addition, the carrier gas may be one type or two or more types. For example, it is acceptable to further use a diluted gas in which the same gas as the first carrier gas is diluted with another gas (for example, being diluted to ten times), as a second carrier gas, and is also possible to use air. In addition, there may be not only one supply point of the carrier gas, but also be two or more points.

The flow rate of the carrier gas is not particularly limited. For example, in the case where the film is formed on the substrate having a diameter of 4 inches (100 mm), the flow rate is preferably 1 to 80 L/min, and more preferably 4 to 40 L/min. The flow rate of the carrier gas in the present invention is a measured value at 20°C and an ordinary pressure, and when having been measured at another temperature and another pressure, or when a different type of flow rate (mass flow rate, or the like) has been measured, the measured value can be converted to a volume flow rate at 20°C and the ordinary pressure with the use of the state equation of gas.

(Film forming unit)

In the film forming unit 840, the mist is heated to cause a thermal reaction, and a film is formed on a part or the whole of the surface of a base body (crystalline substrate) 810. The film forming unit 840 includes, for example, a film forming chamber 807; and the base body (crystalline substrate) 810 is installed in the film forming chamber 807, and a hot plate 808 for heating the base body (crystalline substrate) 810 can be included. The hot plate 808 may be provided outside the film forming chamber 807 as shown in FIG. 9, or may be provided inside the film forming chamber 807. In addition, the film forming chamber 807 may be provided with an exhaust port 812 for exhaust gas at a position that does not affect the supply of mist to the base body (crystalline substrate) 810.

In addition, as shown in a film forming apparatus 800A shown in FIG. 10, the film forming unit 840 may include a moving mechanism 814 for moving the base body 810. A direction to which the substrate is moved is not particularly limited, and may be a reciprocating motion or a rotating motion. In addition, at this time, a mechanism for rotating the substrate may be further provided to rotate the substrate. Due to such a movement of the substrate that the mist is supplied to the whole surface of the substrate, it becomes possible to form a film more stably and uniformly on the whole surface of the substrate even when the substrate has a large diameter such as a diameter of about 15 cm (6 inches), a diameter of about 20 cm (8 inches), or a diameter of about 30 cm (12 inches).

In addition, it is acceptable to place the base body (crystalline substrate) 810 on the top face of the film forming chamber 807 in a direction of face-down, or place the base body (crystalline substrate) 810 on the bottom face of the film forming chamber 807 in a direction of face-up. At this time, it is acceptable to place one base body 810 or two or more base bodies in the film forming chamber 807. When two or more base bodies are placed, it is acceptable to place the base bodies so as to become symmetric with respect to a mist supply port 809b, which supplies the mist to the film forming chamber 807.

In the thermal reaction, the mist may react by heating, and the reaction conditions are not particularly limited. It is possible to appropriately set the reaction conditions depending on the raw material and the film to be formed. For example, it is possible to set a heating temperature to a range of 120 to 600°C, preferably to a range of 200 to 600°C, and more preferably to a range of 300 to 550°C.

The thermal reaction may be performed in any atmosphere of a vacuum, a non-oxygen atmosphere, a reducing gas atmosphere, an air atmosphere and an oxygen atmosphere, and may be appropriately set depending on the film to be formed. In addition, the reaction may be performed under any pressure condition of the atmospheric pressure, an increased pressure, and a reduced pressure, but the film forming under the atmospheric pressure is preferable because the apparatus configuration can be simplified.

(Transport unit)

The transport unit 809 connects the misting unit 820 and the film forming unit 840. The mist is transported by the carrier gas from the mist generating source 804 of the misting unit 820 to the film forming chamber 807 of the film forming unit 840 via the transport unit 809. The transport unit 809 can be, for example, a supply pipe 809a as shown in FIG. 9. In addition, the transport unit 809 can be, for example, the supply pipe 809a and the mist supply port 809b which supplies the mist into the film forming chamber 807, as shown in FIG. 10. As the supply pipe 809a, a quartz pipe, a tube made from a resin or the like can be used, for example.

(Raw material solution)

The raw material solution (aqueous solution) 804a is not particularly limited as long as the solution contains a material that can be misted, and the material may be an inorganic material or an organic material. As the raw material solution, a solution of a metal or a metal compound is suitably used, and the solution can be used which contains one or more metals selected from gallium, iron, indium, aluminum, vanadium, titanium, chromium, rhodium, nickel and cobalt. It is acceptable to set the components and the like from such a raw material solution so as to correspond to the crystalline oxide semiconductor film mainly containing Ga, and the buffer layer containing Al, as in the present invention.

The raw material solution is not particularly limited as long as the above metal solution can be misted, but as the raw material solution, a solution can be suitably used in which a metal is dissolved or dispersed in an organic solvent or water in a form of a complex or a salt. Examples of the form of the complex include an acetylacetonate complex, a carbonyl complex, an ammine complex and a hydride complex. Examples of the form of the salt include a metal chloride salt, a metal bromide salt, and a metal iodide salt. In addition, a solution in which the above metals are dissolved in hydrobromic acid, hydrochloric acid, hydroiodic acid or the like can also be used as an aqueous solution of a salt. A concentration of a solute is preferably 0.01 to 1 mol/L.

In addition, it is acceptable to mix an additive agent such as a halogen-containing substance (for example, hydrohalic acid) and an oxidizing agent, in the raw material solution. Examples of the hydrohalic acid include hydrobromic acid, hydrochloric acid and hydroiodic acid, and among the acids, the hydrobromic acid or the hydroiodic acid is preferable. Examples of the oxidizing agent include: peroxides such as hydrogen peroxide ($H_2O_2$), sodium peroxide ($Na_2O_2$), barium peroxide ($BaO_2$), and benzoyl peroxide ($C_6H_5CO)_2O_2$; and hypochlorous acid (HCIO), perchloric acid, nitric acid and ozone water; and organic peroxides such as peracetic acid and nitrobenzene.

Furthermore, in the raw material solution, a dopant may be contained. The dopant is not particularly limited. Examples of the dopants include: n-type dopants such as tin, germanium, silicon, titanium, zirconium, vanadium and niobium; and p-type dopants such as copper, silver, tin, cobalt, iridium and rhodium. A concentration of the dopant may be, for example, about $1.0 \times 10^{-9}$ to 1.0 mol/L; and may be as low as about $1.0 \times 10^{-7}$ mol/L or lower, or as high as about 0.01 mol/L or higher.

(Base body)

As described above, the base body 810 is not particularly limited as long as a film can be formed and can be supported. The base body may be a known substrate. The base body may be an insulator, a conductor, a semiconductor, a single crystal or a polycrystal. Examples of the material include: polysulfone, poly(ethersulfone), polyphenylene sulfide, polyether ether ketone, polyimide, polyetherimide and fluorine resins; metals such as iron, aluminum, stainless steel and gold; and silicon, sapphire, quartz, glass, gallium oxide, lithium niobate and lithium tantalate; but are not limited to these substances. In addition, a base body is preferably used in which a main component metal element contained in the largest amount is aluminum among the metal elements contained in the base body. Among the base bodies, a sapphire wafer is preferably used from the viewpoint of a quality and a cost.

The plane orientation of the principal plane of the base body is not particularly limited, and in the case of the sapphire wafer, for example, principal planes such as a c-plane, an m-plane and an a-plane can be used. In addition, the plane may have an off-angle with respect to the just plane. The off-angle is not particularly limited, but is preferably 0 to 15°.

A thickness of the base body 810 is not particularly limited, but is preferably about 200 to 800 $\mu$m from the viewpoint of the cost. In addition, an area of the principal surface of the base body 810 is suitably 10 cm$^2$ or larger, is preferably larger than an area corresponding to a diameter of about 5 cm (2 inches), more preferably a diameter of about 10 cm (4 inches) or larger, and further preferably a diameter of about 15 cm (6 inches) or larger. When the diameter of the base body 810 is controlled to be large as in the above, the crystalline oxide semiconductor film formed on the base body 810 results in having a higher quality and a higher productivity. In addition, a degree of freedom of device design is enhanced. A shape of the base body 810 is not particularly limited in the present invention. The shape may be a circle or a quadrangle such as a square.

In the present invention, annealing treatment may be performed after the film formation. A temperature of the annealing treatment is not particularly limited, but is preferably 600°C or lower, and more preferably 550°C or lower. This is because the crystallinity of the film is stabilized and becomes satisfactory. A treatment time period of the annealing treatment is not particularly limited, but is preferably 10 seconds to 10 hours, and is more preferably 10 seconds to 1 hour.

(Film forming method)

Hereinafter, an example of a method for forming the crystalline oxide semiconductor film and the buffer layer according to the present invention will be described with reference to FIGs. 9 and 10. Firstly, the raw material solution 804a is accommodated in the mist generating source 804 of the misting unit 820, the base body (crystalline substrate) 810 is placed on the hot plate 808, and the hot plate 808 is operated.

Next, the flow-rate adjusting valves 803a and 803b are opened to supply the carrier gas from the carrier gas source 802a (main carrier gas) and the carrier gas source 802b for dilution (carrier gas for dilution) into the film forming chamber 807; the atmosphere in the film forming chamber 807 is sufficiently replaced with the carrier gas; and the flow rate of the main carrier gas and the flow rate of the carrier gas for dilution are each controlled by adjustment.

The mist generating step includes: vibrating the ultrasonic vibrator 806, propagating the vibration to the raw material solution 804a through the water 805a; thereby making the raw material solution 804a misted; and generating the mist.

Next, in the mist transporting step of transporting the mist by the carrier gas, the mist is transported by the carrier gas from the misting unit 820 to the film forming unit 840 via the transport unit 809, and is introduced into the film forming chamber 807.

In the film forming step, the mist is supplied onto the base body 810 placed on the hot plate 808, and is heat-treated by the heat of the hot plate 808 in the film forming chamber 807 to cause a thermal reaction; and thereby, a film is formed on the base body 810. When the apparatus shown in FIG. 10 is used, it is also possible to form a film on the base body 810 while moving the base body 810 placed on the hot plate 808 by the substrate moving mechanism 814.

(Separation)

The base body 810 may be separated from the oxide semiconductor film. Separation means is not particularly limited, and may be known means. Examples of the means include: separation means by application of a mechanical impact; separation means by application of heat and by utilization of a thermal stress; separation means by application of vibration such as ultrasonic wave; separation means by etching; and laser lift-off. Due to this separation, the crystalline oxide semiconductor film can be obtained as a self-supported film.

EXAMPLES

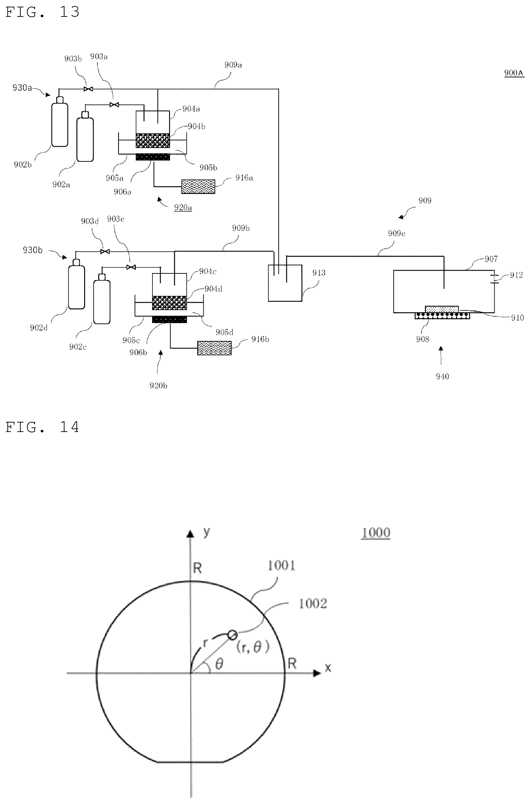

In FIGs. 10 and 12, examples of the film forming apparatus used in the present Example are shown. A film forming apparatus 900A shown in FIG. 13 is an apparatus which does not include a substrate moving mechanism 914 of a film forming apparatus 900 shown in FIG. 12, but even when such a film forming apparatus 900 is used, it is possible to form a crystalline oxide semiconductor film having satisfactory crystallinity in which the buffer layer and the rotational domain are reduced, and the warp and the crack are more reduced.

[Example 1]

1. Film formation of buffer layer

Firstly, the film formation of the buffer layer (buffer film) of the present Example 1 will be described with reference to FIG. 12. In the present Example 1, a c-plane sapphire substrate having a diameter of 4 inches (100 mm) was used as a base body 910, and the buffer layer of $(\alpha\text{-Al}_x\text{Ga}_{1-x})_2\text{O}_3 (0<x<1)$ was formed.

1-1. Preparation step of raw material solution

To a solution in which gallium acetylacetonate was added to water; 1 vol% of HCl was added; the mixture was stirred at 60°C for 120 minutes to dissolve gallium acetylacetonate; and 0.1 mol/L of an aqueous solution was prepared, and was determined to be a Ga raw material solution 904b. The raw material solution of Ga 904b obtained as in the above described way was accommodated in a mist generating source 904a. The temperature of the solution at this time was 25°C.

Subsequently, 1 vol% of HCl was added to the solution in which aluminum acetylacetonate was added to water; the mixture was stirred at 60°C for 120 minutes to dissolve the aluminum acetylacetonate; and 0.1 mol/L of the aqueous solution was prepared, and was determined to be a raw material solution 904d of Al. The raw material solution of Al 904d obtained as in the above described way was accommodated in a mist generating source 904c. The temperature of the solution at this time was 25°C.

1-2. Heating step of base body

Next, as the base body 910, the c-plane sapphire substrate having the diameter of 4 inches (100 mm) was placed on a hot plate 908 in the film forming chamber 907, and the hot plate 908 was operated to raise the temperature to 500°C.

1-3. Supply step of carrier gas

Subsequently, flow-rate adjusting valves 903a, 903b, 903c and 903d of carrier gas supply units 930a and 930b were opened to supply oxygen gas as a carrier gas from a carrier gas source 902a (main carrier gas of Ga), a carrier gas supply source for dilution 902b (carrier gas of Ga for dilution), a carrier gas source 902c (main carrier gas of Al), and a carrier gas supply source for dilution 902d (carrier gas of Al for dilution) into the film forming chamber 907, and the atmosphere in the film forming chamber 907 was sufficiently replaced with these carrier gases; and a flow rate of the main carrier gas of Ga was adjusted to 2 L/min, a flow rate of the carrier gas of Ga for dilution was adjusted to 10 L/min, a flow rate of the main carrier gas of Al was adjusted to 10 L/min, and a flow rate of the carrier gas of Al for dilution was adjusted to 2 L/min, respectively.

1-4. Film forming step

Next, ultrasonic vibrators 906a and 906b were vibrated at 2.4 MHz by oscillators 916a and 916b, and the vibrations were propagated to the raw material solution of Ga 904b and the raw material solution of Al 904d through waters 905b and 905d in vessels 905a and 905c, and thereby, the raw material solution of Ga 904b and the raw material solution of Al 904d were misted to generate mist.

The mist was transported to the mist mixer 913 through transport pipes 909a and 909b by the carrier gas, and the mists of the raw material solution of Ga 904b and the raw material solution of Al 904d were mixed in the mist mixer 913. The mist which was mixed in the mist mixer 913 was transported to the film forming chamber 907 of a film forming unit 940 through a supply pipe 909c of a transport unit 909 by the carrier gas, and the mist was supplied onto the base body 910.

Then, the mist was thermally reacted in the film forming chamber 907 under the condition of 500°C under the atmospheric pressure, while the gas was exhausted from an exhaust port 912, and thereby, a thin film of a first layer of a buffer film $(\alpha\text{-Al}_{x1}\text{Ga}_{1-x1})_2\text{O}_3 (0<x1<1)$ having a corundum structure was formed on the base body 910. At this time, the film was formed while the substrate was reciprocated at a rate of 2.5 mm/sec on a width of 150 mm centered on a mist supply port 909d, by the substrate moving mechanism 914. The film forming time was set to 60 minutes. At this time, the raw material solution of Ga 904b and the raw material solution of Al 904d were replenished into the mist generating sources 904a and 904b with the use of a replenishing mechanism (not shown) as appropriate so that the heights of the water surfaces of the raw material solution of Ga 904b in the mist generating source 904a and the raw material solution of Al 904d in the mist generating source 904c became constant during the film formation.

Subsequently, the flow rates of the carrier gases in the above "1-3. supply step of carrier gas " were adjusted so that the flow rate of the main carrier gas of Ga became 4 L/min, the flow rate of the carrier gas of Ga for dilution became 8 L/min, the flow rate of the main carrier gas of Al became 8 L/min, and the flow rate of the carrier gas of Al for dilution became 4 L/min, respectively; and this film forming step was performed in the same way as in the above, and a thin film of a second layer of the buffer film ($\alpha$-Al$_{x2}$Ga$_{1-x2}$)$_2$O$_3$ (0<x2<x1) was formed on the first layer of the buffer film ($\alpha$-Al$_{x1}$Ga$_{1-x1}$)$_2$O$_3$ (0<x1<1).

After that, the flow rates of the carrier gas in the above "1-3. supply step of carrier gas " were adjusted so that the flow rate of the main carrier gas of Ga became 6 L/min, the flow rate of the carrier gas of Ga for dilution became 6 L/min, the flow rate of the main carrier gas of Al became 6 L/min and the flow rate of the carrier gas of Al for dilution became 6 L/min, respectively; and the "1-4. film forming step" was performed in the same way as in the above, and a thin film of a third layer of the buffer film ($\alpha$-Al$_{x3}$Ga$_{1-x3}$)$_2$O$_3$ (0<x3<x2) was formed on the second layer of the buffer film ($\alpha$-Al$_{x2}$Ga$_{1-x2}$)$_2$O$_3$ (0<x2<x1); and the formation of the buffer film was completed.

2. Film formation of crystalline oxide semiconductor film

Next, the film formation of the crystalline oxide semiconductor film in the present Example 1 will be described with reference to FIG. 10.

2-1. Preparation step of raw material solution

Gallium iodide and Tin (II) chloride dihydrate were added to water so that an atomic ratio of tin to gallium became 1: 0.01, were stirred in the mixture at 60°C for 60 minutes, and were dissolved in the water; and thus 0.1 mol/L of an aqueous solution was prepared, and was determined to be a raw material solution 804a. The raw material solution 804a obtained as described above was accommodated in the mist generating source 804. A temperature of the solution at this time was 25°C.

2-2. Heating step

Next, the base body 810 on which the buffer layer was formed in the above "1. Film formation of buffer film" was placed on the hot plate 808 in the film forming chamber 807, and the hot plate 808 was operated to raise the temperature to 500°C.

2-3. Supply step of carrier gas

Subsequently, the flow-rate adjusting valves 803a and 803b were opened to supply nitrogen gas as the carrier gases from the carrier gas source 802a (main carrier gas) and a carrier gas supply source 802b for dilution (carrier gas for dilution) into the film forming chamber 807; the atmosphere in the film forming chamber 807 was sufficiently replaced with these carrier gases; and the flow rate of the main carrier gas was adjusted to 12 L/min, and the flow rate of the carrier gas for dilution was adjusted to 12 L/min, respectively.

2-4. Film forming step

Next, the mist was generated by vibrating the ultrasonic vibrator 806 at 2.4 MHz, propagating the vibration to the raw material solution 804a through the water 805a, and thereby making the raw material solution 804a misted.

The mist was transported to the film forming chamber 807 through the supply pipe 809a by the carrier gas, and the mist was supplied onto the base body 810.

Then, the mist was thermally reacted in the film forming chamber 807 under the condition of 500°C under the atmospheric pressure, while the gas was exhausted from the exhaust port 812, and thereby, a film of the $\alpha$-Ga$_2$O$_3$ having a corundum structure was formed on the base body 810. At this time, the film was formed while the substrate was reciprocated at a rate of 2.5 mm/sec on a width of 150 mm centered on the mist supply port 809b, by the substrate moving mechanism 814 shown in FIG. 10. The film forming time was set to 150 minutes. At this time, the raw material solution 804a was replenished into the mist generating source 804 with the use of a replenishing mechanism (not shown) as appropriate so that the height of the water surface of the raw material solution 804a in the mist generating source 804 became constant during the film formation.

(Evaluation)

1. Film thickness measurement

The film thicknesses of the buffer film formed on the base body 910 and the crystalline oxide semiconductor film formed on the buffer film were measured at measurement points of 25 points in the plane on the base body 910, with the use of an optical interference film thickness meter F50.

At this time, the measurement was performed as a layered product of four layers having different refractive indices. As shown in FIG. 14, the measurement was performed at the measurement point 1002 that was 25 points in total, which were polar coordinates $(r, \theta) = (0, 0), (0.3R, \theta), (0.6R, \theta)$ and $(0.9R, \theta)$, and $\theta$ [°] = 0, 45, 90, 135, 180, 225, 270 and 315, in a polar coordinate system in which the radius of the substrate was R, the center of the substrate was the origin 0, and a distance from the origin 0 was defined as r, and an angle formed with the x-axis was defined as $\theta$ [°].

The mean film thicknesses of the buffer films were calculated from the respective values, and as a result, the thickness of the first layer of the buffer film was 250 nm, the second layer was 400 nm, the third layer was 550nm, and the crystalline oxide semiconductor film was 7.6 $\mu$m.

The distribution of the film thicknesses of the crystalline oxide semiconductor film at 25 measurement points (= (maximum film thickness - minimum film thickness)/2/ mean film thickness $\times$100) was $\pm$1.9%; the standard deviation was 0.07 $\mu$m; and the coefficient of variation (= standard deviation / mean film thickness) was 0.009.

In addition, the film forming rate was calculated from the mean film thickness and film forming time of each film, and was 4.2 nm/min for the first layer of the buffer film, 6.6 nm/min for the second layer, 9.2 nm/min for the third layer, and 3 $\mu$m/hour for the crystalline oxide semiconductor film.

Subsequently, for the measurement of the warp, the shortest distance between the shortest straight line passing through points of both ends between the 5 mm portions and the apex of the concave or convex portion was measured. The warp was 0.14 $\mu$m.

Subsequently, the presence or absence of cracks in 1 mm$^2$ was observed with the use of an optical microscope. Then, the crack was not observed in the observation range.

2. Evaluation of crystal structure

The buffer film formed on the base body 910 and the crystalline oxide semiconductor film formed on the buffer film were subjected to a XRD $2\theta/\omega$ scan, and as a result, a peak which was considered to be derived from the (006) plane of the sapphire substrate was observed at $2\theta = 41.7°$. In addition, a peak was observed at $2\theta = 40.3°$. The peak was considered to be derived from the (006) plane of $\alpha$-Ga$_2$O$_3$, and it was assumed that the obtained crystalline oxide semiconductor film was $\alpha$-Ga$_2$O$_3$.

In addition, further three peaks were observed between $2\theta = 40.3°$ and $41.7°$. These peaks are considered to be derived from the (006) plane of the buffer film ($\alpha$-Al$_x$Ga$_{1-x}$)$_2$O$_3$ (0<x<1). The peaks are considered to be a first layer of the buffer film ($\alpha$-Al$_{x1}$Ga$_{1-x1}$)$_2$O$_3$ (0<x1<1), a second layer of the buffer film ($\alpha$-Al$_{x2}$Ga$_{1-x2}$)$_2$O$_3$ (0<x2<x1), and a third layer of the buffer film ($\alpha$-Al$_{x3}$Ga$_{1-x3}$)$_2$O$_3$ (0<x3<x2), in order from the high angle side.

Subsequently, the half-value width was measured from the $\omega$ scan of the (006) plane of the $\alpha$-Ga$_2$O$_3$, and as a result, the half-value width was 8.6 s. It was confirmed that a high-quality $\alpha$-Ga$_2$O$_3$ was formed.

3. Evaluation of rotational domain

(1) $2\theta/\omega$ scan in Out-of-Plane XRD

The buffer film formed on the base body 910 and the (104) plane of the crystalline oxide semiconductor film formed on the buffer film were subjected to $2\theta/\omega$ scan in the Out-of-Plane XRD measurement, with the use of an X-ray diffractometer (SmartLab manufactured by Rigaku Corporation). The (104) plane is inclined at about 38° with respect to the c-axis direction, and the sample was measured in a state in which the sample was inclined by an operation of the $\chi$-axis. In addition, the measurement conditions are shown below.

●Measurement device: SmartLab (product name) manufactured by Rigaku Corporation
●Analysis conditions

Measurement method: Out-of-Plane XRD method ($2\theta/\omega$ scan)
X-ray generating unit: counter cathode Cu
 : output 45 kV, 200 mA
Detection unit: semiconductor detector

Incident optical system: Ge(220) channel cut monochromator
Soller slit: incident side -
: light receiving side 5.0°
Slit: incident side IS=1 (mm)

| | |
|---|---|
| : longitudinal limitation | 0.5 (mm) |
| : light receiving side | RS1=1 RS2=1.1 (mm) |

Scanning condition: scanning axis $2\theta/\omega$

| | |
|---|---|
| : scanning mode | step measurement |
| : scanning range | 30 to 38° |
| : step width | 0.005° |
| : accumulation timeperiod | 0.5 |

sec./step

(2) $\omega$ scan

The diffraction angle was fixed at 20 at which the peak was obtained in the above (1), and $\omega$ scan was performed. The half-value width of the rocking curve of the (104) plane was 1321 s. The measurement conditions are shown in the followings.

●Measurement device: SmartLab (product name) manufactured by Rigaku Corporation
●Analysis conditions

Measurement method: rocking curve measurement ($\omega$ scan)
X-ray generating unit: counter cathode Cu
: output 45 kV 200 mA
Detection unit: semiconductor detector
Incident optical system: Ge(220) channel cut monochromator
Soller slit: incident side -
: light receiving side 5.0°
Slit: incident side IS=1 (mm)

| | |
|---|---|
| : longitudinal limitation | 0.5 (mm) |
| : light receiving side | RS1=1 RS2= 1.1 (mm) |

Scanning conditions: evaluation diffraction surface $Ga_2O_3$ (104)

| | |
|---|---|
| : scanning axis | $\omega$ |
| : scanning mode | step measurement |
| : scanning range | 13 to 21° |
| : step width | 0.005° |
| : accumulation timeperiod | 0.5 |

sec./step

(3) $\phi$ scan

At the position at which the peak was obtained in the above (2), 20 and $\omega$ were fixed, and the $\phi$-axis parallel to the normal line of the sample surface was rotated; and thereby the $\phi$ scan of the (104) plane was performed. A content ratio of the rotational domain was calculated with the use of a total area (C1) of the peaks which have appeared in the $\phi$ scan and

the total area (C2) of the peaks of the rotational domain, according to (content ratio of rotational domain [%]) = C2/C1 ×100. In the $\phi$ scan in the present Example 1, as in FIG. 1, only three-fold symmetric peaks at about 89°, about 209° and about 329° were observed, and peaks derived from three-fold symmetric rotational domains at about 29°, about 149° and about 269° were not observed. Because of this, as shown in the following Table 1, the content ratio [%] of the rotational domain was 0% (= 0/ $3.81 \times 10^7$ ×100). In addition, the count number of the peak of the highest intensity of the rotational domain with respect to the count number of the peak of the highest intensity of the $\phi$ scan was 0 count with respect to 343,375 counts.

Subsequently, measurements of the above (1) to (3) were performed at five points in total, which were polar coordinates (r, $\theta$) = (0, 0), (0.5R, 0), (0.5R, 90), (0.5 R, 180) and (0.5R, 270), as shown in FIG. 14, in a polar coordinate system in which a radius of a crystalline oxide semiconductor film 1001 formed on a base body 1000 was set to R, the center of the crystalline oxide semiconductor film 1001 was set to the origin 0, the distance from the origin 0 was set to r, and an angle formed with the x-axis was set to $\theta$. In the present Example, a size of the base body was 4 inches (100 mm), and accordingly R became 50 mm; and the measured points are five points of (r, $\theta$) = (0, 0), (25, 0), (25, 90), (25, 180) and (25, 270). At any of the five measured points, the peak derived from the rotational domain was not detected, and it was found that the content ratio of the rotational domain was 0%. FIG. 1 shows the results at the measurement point (0, 0). In addition, the measurement conditions are shown in the followings.

(X-Ray measurement condition: $\phi$ scan)

Measurement method: rocking curve measurement ($\theta$ scan)

X-ray generating unit: counter cathode Cu

: output 45 kV 200 mA

Detection unit: semiconductor detector

Incident optical system: Ge(220) channel cut monochromator

Soller slit: incident side -

: light receiving side 5.0°

Slit: incident side IS=1 (mm)

: longitudinal limitation 0.5 (mm)

: light receiving side RS1=1 RS2= 1.1 (mm)

Scanning conditions: evaluation diffraction surface Ga$_2$O$_3$ (104)

| : scanning axis | $\phi$ |
| --- | --- |
| : scanning mode | continuous scan |
| : scanning range | 0 to 360° |
| : step width | 0. 02° |
| : scanning speed | 12°/min |

[Comparative Example 1]

A film was formed in the same way as in Example 1, except that "1. Film formation of buffer layer" was not performed and the film forming time in "2-4. Film forming step" was set to 240 minutes. The same evaluation as in Example 1 was performed, and as a result, the film thickness of the crystalline oxide semiconductor film was 6.0 $\mu$m, and the film forming rate of the crystalline oxide semiconductor film was 1.5 $\mu$m/hour.

The distribution of the film thicknesses of the crystalline oxide semiconductor film at 25 measurement points (= (maximum film thickness - minimum film thickness)/2/ mean film thickness ×100) was ±7.1%; the standard deviation was 0.22 $\mu$m; and the coefficient of variation (= standard deviation / mean film thickness) was 0.037. In addition, the warp was 0.34 $\mu$m, and numerous cracks were also observed in the plane.

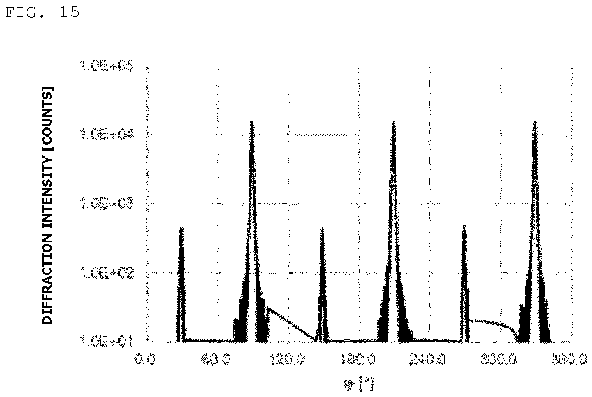

From the evaluation by XRD, it was found that the $\alpha$-Ga$_2$O$_3$ was formed. In addition, the half-value width of the rocking curve of the (006) plane was 40.1 s, and the half-value width of the rocking curve of the (104) plane was 3544 s. Furthermore, when the $\phi$ scan of the (104) plane was performed, as shown in FIG. 15, peaks derived from three-fold symmetric rotational domains were observed at about 29°, about 149° and about 269°, in addition to the three-fold symmetric peaks at about 89°, about 209° and about 329°. The content ratio of the rotational domain was calculated, and as a result, was 1.95% (= $1.56 \times 10^4$/ $7.99 \times 10^5$ ×100). FIG. 15 shows the results at the measurement point (0, 0), but peaks of the rotational domain were observed at all of five points in total of polar coordinates (r, $\theta$) = (0, 0), (0.5R, 0), (0.5R, 90), (0.5R, 180), and (0.5R, 270), in the polar coordinate system shown in FIG. 14. The maximum value of the five points was 3.28%, and the minimum value was 1.24%. The median value of the five points was 1.95%. At the point at which the content ratio of the rotational domain was minimum and 1.24%, a ratio of the rotational domain to the total peak area of 798,699 counts was 9,903 counts, and the ratio of the rotational domain to 1,000,000 counts was 13,400 counts. In addition, an average value of the five points was 2.1, the variance given by the sum of squares of the differences between the average value and the respective values was 0.55, the standard deviation which is the 1/2 power of the variance was 0.74, and the coefficient of variation was 0.35, which is represented by the quotient of the standard deviation and the average value.

In addition, the count number of the peak of the highest intensity of the rotational domain with respect to the count number of the peak of the highest intensity of the $\phi$ scan was 332 counts with respect to 14,983 counts.

[Example 2]

A buffer layer was formed in the same way as in Example 1, except that a sapphire substrate of 6 inches (150 mm) was used as the base body, the flow rate of each gas was doubled, and the film was formed while the substrate was reciprocated at a rate of 2.5 mm/sec on a width of 200 mm centered on the mist supply port 909d, by the substrate moving mechanism 914. After that, a film was formed in the same way as in Example 1, except that in the "2-1. Preparation step of raw material solution", germanium oxide was used instead of tin (II) chloride dihydrate, and 0.1 mol/L of an aqueous solution of gallium bromide was prepared so that an atomic ratio of gallium to germanium was 1: 0.01; that the flow rate of each gas in "2-3. Supply step of carrier gas" was doubled; and that the film forming time in the "2-4. film forming step" was set to 120 minutes, and the film was formed while the substrate was reciprocated at a rate of 2.5 mm/sec on a width of 200 mm centered on the mist supply port 809b, by the substrate moving mechanism 814.

The same evaluation as in Example 1 was performed; and as a result, the film thickness of the crystalline oxide semiconductor film was 5.1 $\mu$m, and the film forming rate of the crystalline oxide semiconductor film was 2.6 $\mu$m/hour. The distribution of the film thicknesses of the crystalline oxide semiconductor film at 25 measurement points (= (maximum film thickness - minimum film thickness)/2/ mean film thickness $\times$100) was $\pm$3.6%; the standard deviation was 0.08 $\mu$m; and the coefficient of variation (= standard deviation / mean film thickness) was 0.016. In addition, the warp was 0.15 $\mu$m. In addition, the crack was not observed in the 1 mm$^2$.

From the evaluation by XRD, it was found that the $\alpha$-Ga$_2$O$_3$ was formed. In addition, the half-value width of the rocking curve of the (006) plane was 15.1 s, and the half-value width of the rocking curve of the (104) plane was 1726 s. Furthermore, when the $\phi$ scan of the (104) plane was performed, only the three-fold symmetric peaks were observed at about 89°, about 209° and about 329°, as in FIG. 1. A content ratio of the rotational domain was calculated, and as a result, was 0% (= 0/ 3.80$\times$10$^6$ $\times$100). In the polar coordinate system shown in FIG. 14, the peak of the rotational domain was not observed at any of five points in total of polar coordinates (r, $\theta$) = (0, 0), (0.5R, 0), (0.5R, 90), (0.5R, 180) and (0.5R, 270). In addition, the count number of the peak of the highest intensity of the rotational domain with respect to the count number of the peak of the highest intensity of the $\phi$ scan was 0 count with respect to 170,990 counts.

[Example 3]

A buffer layer was formed in the same way as in Example 1, except that a sapphire substrate of 8 inches (150 mm) was used as the base body, the flow rate of each gas was quadrupled, and the film was formed while the substrate was reciprocated at a rate of 2.5 mm/sec on a width of 250 mm centered on the mist supply port 909d, by the substrate moving mechanism 914; then a film was formed in the same way as in Example 1, except that in the "2-1. Preparation step of raw material solution", chloro(2-cyanoethyl) dimethyl silane (ClSi(CH$_3$)$_2$((CH$_2$)$_2$CN)) was used instead of tin (II) chloride dihydrate, and 0.1 mol/L of an aqueous solution of gallium acetylacetonate was prepared which contained 1 vol% of hydrochloric acid so that an atomic ratio of gallium to Si was 1: 0.01, and was used as a raw material solution 804a; and that the flow rate of each gas in "2-3. Supply step of carrier gas" was quadrupled, the film forming time in "2-4. Film forming step" was set to 210 minutes, and the film was formed while the substrate was reciprocated at a rate of 2.5 mm/sec on a width of 250 mm centered on the mist supply port 809b, by the substrate moving mechanism 814.

The same evaluation as in Example 1 was performed; and as a result, the film thickness of the crystalline oxide semiconductor film was 10.0 $\mu$m, and the film forming rate of the crystalline oxide semiconductor film was 2.9 $\mu$m/hour. The distribution of the film thicknesses of the crystalline oxide semiconductor film at 25 measurement points (= (maximum film thickness - minimum film thickness) /2/ mean film thickness $\times$100) was $\pm$2.7%; the standard deviation was 0.12 $\mu$m; and the coefficient of variation (= standard deviation / mean film thickness) was 0.012. In addition, the warp was 0.15 $\mu$m. In addition, the crack was not observed in the 1 mm$^2$.

From the evaluation by XRD, it was found that the $\alpha$-Ga$_2$O$_3$ was formed. In addition, the half-value width of the (006) plane was 9.8 s, and the half-value width of the rocking curve of the (104) plane was 1283 s. Furthermore, when the $\phi$ scan of the (104) plane was performed, only the three-fold symmetric peaks were observed at about 89°, about 209° and about 329°, as in FIG. 1. A content ratio of the rotational domain was calculated, and as a result, was 0% (= 0/ 3.54$\times$10$^7$ $\times$100). The peak of the rotational domain was not observed at any of five points in total of polar coordinates (r, $\theta$) = (0, 0), (0.5R, 0), (0.5R, 90), (0.5R, 180) and (0.5R, 270), in the polar coordinate system shown in FIG. 14. In addition, the count number of the peak of the highest intensity of the rotational domain with respect to the count number of the peak of the highest intensity of the $\phi$ scan was 0 count with respect to 305,301 counts.

[Comparative Example 2]

A film was formed in the same way as in Example 1, except that in "1. Film formation of buffer layer", the third layer of the buffer film $(\alpha\text{-Al}_{x3}\text{Ga}_{1-x3})_2\text{O}_3$ (x3<x2<1) was not formed, and the first layer of the $(\alpha\text{-Al}_{x1}\text{Ga}_{1-x1})_2\text{O}_3$ (0<x1<1) and the second layer of the $(\alpha\text{-Al}_{x2}\text{Ga}_{1-x2})_2\text{O}_3$ (0<x2<x1) were formed (in other words, the buffer layer was two layers in total), the film forming time was set to 30 minutes, and the film forming time in "2-4. Film forming step" was set to 240 minutes.

The same evaluation as in Example 1 was performed, and as a result, the film thicknesses of the first layer of the buffer film, the second layer thereof and the crystalline oxide semiconductor film was 130 nm, 200 nm and 6.4 $\mu$m, respectively, and the film forming rate of the crystalline oxide semiconductor film was 1.6 $\mu$m/hour. The distribution of the film thicknesses of the crystalline oxide semiconductor film at 25 measurement points (= (maximum film thickness - minimum film thickness)/2/ mean film thickness $\times$100) was $\pm$6.5%; the standard deviation was 0.21 $\mu$m; and the coefficient of variation (= standard deviation / mean film thickness) was 0.033. In addition, the warp was 0.25 $\mu$m, and numerous cracks were also observed in the plane.

From the evaluation by XRD, it was found that the $\alpha\text{-Ga}_2\text{O}_3$ was formed. In addition, the half-value width of the (006) plane was 25.1 s, and the half-value width of the rocking curve of the (104) plane was 2542 s. Furthermore, when the $\phi$ scan of the (104) plane was performed, an extremely slight peaks derived from three-fold symmetric rotational domains were observed at about 29°, about 149° and about 269°, in addition to the three-fold symmetric peaks at about 89°, about 209° and about 329°. The content ratio of the rotational domain was calculated, and as a result, was 0.005% (= $1.25\times10^2$ / $2.50\times10^7\times100$). The peak of the rotational domain was observed at any of five points in total of polar coordinates (r, $\theta$) = (0, 0), (0.5R, 0), (0.5R, 90), (0.5R, 180) and (0.5R, 270), in the polar coordinate system shown in FIG. 14. The maximum value of the content ratios of the rotational domains at the five points was 0.007%, and the minimum value thereof was 0.002%. In addition, the median value of the five points was 0.005%. At the point of 0.002% which is the minimum, the rotational domain was 500 counts with respect to 25,014,264 counts, which was a ratio of 20 counts to 1,000,000 counts.

In addition, an average value of the five points was 0.005, the variance given by the sum of squares of the differences between the average value and the respective values was $3.44\times10^{-6}$, the standard deviation which is the 1/2 power of the variance was 0.0018, and the coefficient of variation was 0.40, which is represented by a quotient of the standard deviation and the average value.

In addition, the count number of the peak of the highest intensity of the rotational domain with respect to the count number of the peak of the highest intensity of the $\phi$ scan was 210 counts with respect to 141,426 counts.

[Example 4]

A film was formed in the same way as in Example 1, except that in "1. Film formation of buffer layer", the film forming time was set to 30 minutes.

The same evaluation as in Example 1 was performed, and as a result, the film thicknesses of the first layer of the buffer film, the second layer thereof, the third layer thereof and the crystalline oxide semiconductor film was 130 nm, 200 nm, 270 nm and 9.0 $\mu$m, respectively, and the film forming rate of the crystalline oxide semiconductor film was 3.6 $\mu$m/hour. The distribution of the film thicknesses of the crystalline oxide semiconductor film at 25 measurement points (= (maximum film thickness - minimum film thickness)/2/ mean film thickness $\times$100) was $\pm$1.8%; the standard deviation was 0.10 $\mu$m; and the coefficient of variation (= standard deviation / mean film thickness) was 0.011. In addition, the warp was 0.17 $\mu$m, and the crack was not observed in the plane.

From the evaluation by XRD, it was found that the $\alpha\text{-Ga}_2\text{O}_3$ was formed. In addition, the half-value width of the (006) plane was 19.1 s, and the half-value width of the rocking curve of the (104) plane was 1948 s. Furthermore, when the $\phi$ scan of the (104) plane was performed, extremely slight peaks derived from three-fold symmetric rotational domains were observed at about 29°, about 149° and about 269°, in addition to the three-fold symmetric peaks at about 89°, about 209° and about 329°. The content ratio of the rotational domain was calculated, and as a result, was $3.49\times10^{-4}$% (= $1.78\times10^2$ / $3.64\times10\times100$). The peak of the rotational domain was observed at any of five points in total of polar coordinates (r, $\theta$) = (0, 0), (0.5R, 0), (0.5R, 90), (0.5R, 180) and (0.5R, 270), in the polar coordinate system shown in FIG. 14. The maximum value of the content ratios of the rotational domains at the five points was $4.97\times10^{-4}$%, and the minimum value thereof was $2.47\times10^{-4}$%. The median value of the five points was $3.49\times10^{-4}$%. At the point of $2.47\times10^{-4}$% which was minimum, the rotational domain was 90 counts with respect to 36, 421, 252 counts, which was a ratio of 2 counts to 1,000,000 counts.

In addition, an average value of the five points was $3.53\times10^{-4}$%, the variance given by the sum of squares of the differences between the average value and the respective values was $7.66\times10^{-9}$, the standard deviation which is the 1/2 power of the variance was $8.75\times10^{-5}$%, and the coefficient of variation was 0.25, which is represented by the quotient of the standard deviation and the average value.

In addition, the count number of the peak of the highest intensity of the rotational domain with respect to the count number of the peak of the highest intensity of the $\phi$ scan was 32 counts with respect to 288,301 counts.

[Table 1]

| | Example 1 | Comparative Example 1 | Example 2 | Example 3 | Example 2 | Example4 |
|---|---|---|---|---|---|---|
| Presence or absence of buffer layer | Present (3 layers) | Absent (0 layer) | Present (3 layers) | Present (3 layers) | Present (2 layers) | Present (3 layers) |
| $\alpha$-Ga$_2$O$_3$ film thickness [$\mu$m] | 7.6 | 6.0 | 5.1 | 10 | 6.4 | 9 |
| Coefficient of variation of film thicknesses at 25 points [-] | 0.009 | 0.0 | 0.0 | 0.012 | 0.033 | 0.011 |
| $\alpha$-Ga$_2$O$_3$ film forming rate [$\mu$m/hour] | 3.0 | 1.5 | 2.6 | 2.9 | 1.6 | 3.6 |
| Warp [$\mu$m] | 0.14 | 0.34 | 0.15 | 0.15 | 0.25 | 0.17 |
| Crack | Absent | Present | Absent | Absent | Present | Absent |
| $\alpha$-Ga$_2$O$_3$ (006) half-value width [s] | 8.6 | 40.1 | 15.1 | 9.8 | 25.1 | 19.1 |
| $\alpha$-Ga$_2$O$_3$ (104) half-value width [s] (median value of 5 points) | 1321 | 3544 | 1726 | 1283 | 2542 | 1948 |
| Count number of highest intensity peak [counts] | 3.43E+05 | 1.50E+04 | 1.71E+05 | 3.05E+05 | 1.41E+05 | 2.88E+05 |
| Count number of highest intensity peak in rotational domain [counts] | 0 | 332 | 0 | 0 | 210 | 32 |
| Total peak area C1 [counts] (median value of 5 points) | 3.81E+07 | 7.99E+05 | 3.80E+06 | 3.54E+07 | 2.50E+07 | 3.64E+07 |
| Total peak area C2 of rotation domain [counts] (median value of 5 points) | 0 | 1.56E+04 | 0 | 0 | 1.25E+03 | 1.78E+02 |
| Content ratio of rotational domain [%] (median value of 5 points) | 0.00 | 1.95 | 0.00 | 0.00 | 0.005 | 3.49E-04 |
| Content ratio of rotational domain [%] (minimum value of 5 points) | 0.00 | 1.24 | 0.00 | 0.00 | 0.002 | 2.47E-04 |
| C2 area to C1 area of 1,000,000 counts [counts] (minimum value of 5 points) | 0.00 | 1.34E+04 | 0.00 | 0.00 | 20 | 2 |

(continued)

|  | Example 1 | Comparative Example 1 | Example 2 | Example 3 | Example 2 | Example4 |
|---|---|---|---|---|---|---|
| Coefficient of variation of rotational domain at 5 points [-] | 0.00 | 0.35 | 0.00 | 0.00 | 0.40 | 0.25 |

From the results of Table 1, FIG. 1 and FIG. 15, it is understood that the $\alpha$-Ga$_2$O$_3$ films of Examples do not have the rotational domain, are excellent in film qualities such as crystallinity, and are reduced in the warp and the crack. Furthermore, according to Examples, a crystalline oxide semiconductor film was obtained in which the coefficient of variation of the content ratios of the rotational domains which were measured at five points in the plane of the crystalline oxide semiconductor film was lower (less than 0.35) than that of Comparative Examples.

In addition, the $\alpha$-Ga$_2$O$_3$ films of Examples 1 to 4 and Comparative Examples 1 to 2 were subjected to Hall effect measurement. The results are shown in the following Table 2. From the results of Table 2, it is understood that the crystalline oxide semiconductor film of the present invention is excellent also in electrical properties.

[Table 2]

|  | Example 1 | Comparative Example 1 | Example 2 | Example 3 | Comparative Example 2 | Example 4 |
|---|---|---|---|---|---|---|
| Sheet resistance [$\Omega\cdot$cm] | 1.26E+02 | 1.51E+03 | 2.16E+02 | 1.04E+02 | 9.12E+02 | 1.35E+02 |
| Carrier concentration [cm$^{-3}$] | 9.80E+18 | 8.00E+18 | 9.40E+18 | 9.80E+18 | 1.08E+19 | 1.00E+19 |
| Mobility [cm$^2$/V$\cdot$S] | 6.65 | 0.86 | 6.03 | 6.12 | 0.99 | 5.14 |

The present description includes the following embodiments.

[1] A crystalline oxide semiconductor film, wherein
the crystalline oxide semiconductor film is a uniaxially oriented film containing $\alpha$-Ga$_2$O$_3$ as a main component, wherein a total area (C2) of peaks of a rotational domain with respect to a total area (C1) of peaks of the crystalline oxide semiconductor film, which are obtained by $\varphi$ scan of X-ray diffraction measurement of an asymmetric plane of the crystalline oxide semiconductor film, is the total area (C2) of the peaks of the rotational domain being less than 5 counts with respect to 1,000,000 counts of the total area (C1) of the peaks of the crystalline oxide semiconductor film.
[2] The crystalline oxide semiconductor film according to the above [1], wherein the total area (C2) of the peaks of the rotational domain is 0 count with respect to 1,000,000 counts of the total area (C1) of the peaks of the crystalline oxide semiconductor film.
[3] A crystalline oxide semiconductor film, wherein
the crystalline oxide semiconductor film is a uniaxially oriented film containing $\alpha$-Ga$_2$O$_3$ as a main component, wherein a total area (C2) of peaks of a rotational domain with respect to a total area (C1) of peaks of the crystalline oxide semiconductor film, which are obtained by $\varphi$ scan of X-ray diffraction measurement of an asymmetric plane of the crystalline oxide semiconductor film, is the total area (C2) of the peaks of the rotational domain being 0 count with respect to 500,000 counts of the total area (C1) of the peaks of the crystalline oxide semiconductor film.
[4] The crystalline oxide semiconductor film according to any one of the above [1] to [3], wherein the crystalline oxide semiconductor film comprises a dopant.
[5] The crystalline oxide semiconductor film according to any one of the above [1] to [4], wherein a thickness of the crystalline oxide semiconductor film is 1 $\mu$m or larger.
[6] The crystalline oxide semiconductor film according to any one of the above [1] to [5], wherein Ga accounts for 90 atom% or more of metals contained in the crystalline oxide semiconductor film.
[7] The crystalline oxide semiconductor film according to any one of the above [1] to [6], wherein the crystalline oxide semiconductor film has a size with a diameter of 2 inches (50 mm) or larger.
[8] The crystalline oxide semiconductor film according to any one of the above [1] to [7], wherein the crystalline oxide semiconductor film has a size with a diameter of 6 inches (150 mm) or larger.
[9] The crystalline oxide semiconductor film according to any one of the above [1] to [8], wherein a half-value width of a rocking curve in a plane parallel to a principal plane of the crystalline oxide semiconductor film is 25 arcsec or smaller, and a half-value width of a rocking curve in the asymmetric plane is 2500 arcsec or smaller.

[10] The crystalline oxide semiconductor film according to any one of the above [1] to [9], wherein the crystalline oxide semiconductor film has a c-plane as a principal plane.

[11] The crystalline oxide semiconductor film according to the above [10], wherein a half-value width of a rocking curve of a (006) plane of the crystalline oxide semiconductor film is 25 arcsec or smaller.

[12] The crystalline oxide semiconductor film according to the above [10] or [11], wherein a half-value width of a rocking curve of a (104) plane of the crystalline oxide semiconductor film is 2500 arcsec or smaller.

[13] The crystalline oxide semiconductor film according to any one of the above [1] to [12], wherein the number of cracks of the crystalline oxide semiconductor film is zero per $mm^2$.

[14] The crystalline oxide semiconductor film according to any one of the above [1] to [13], wherein a content ratio [%] of the rotational domain is less than 0.0005%, which is calculated from a total peak area (C1) of the crystalline oxide semiconductor film and the total area (C2) of the peaks of the rotational domain, according to C1/C2 $\times$100.

[15] The crystalline oxide semiconductor film according to the above [14], wherein the content ratios of the rotational domains are all less than 0.0005% in the measurements at five points in a plane of the crystalline oxide semiconductor film.

[16] The crystalline oxide semiconductor film according to the above [14] or [15], wherein a coefficient of variation of the content ratios of the rotational domains is less than 0.35, which are measured at five points in a plane of the crystalline oxide semiconductor film.

[17] The crystalline oxide semiconductor film according to any one of the above [1] to [16], wherein a content ratio [%] of the rotational domain is less than 0.0002%, which is calculated from a total peak area (C1) of the crystalline oxide semiconductor film and the total area (C2) of the peaks of the rotational domain, according to C1/C2 $\times$100.

[18] The crystalline oxide semiconductor film according to the above [17], wherein the content ratios of the rotational domains are all less than 0.0002% in the measurements at five points in a plane of the crystalline oxide semiconductor film.

[19] The crystalline oxide semiconductor film according to any one of the above [1] to [18], wherein the count number of peaks having the highest intensity among peaks of the rotational domain is 0 count with respect to 150,000 counts of the count number of the peaks having the highest intensity among peaks that are obtained by $\varphi$ scan of the X-ray diffraction measurement of the asymmetric plane of the crystalline oxide semiconductor film.

[20] A layered structure comprising: a base body; and a crystalline oxide semiconductor film layered on the base body via a buffer layer, wherein

the buffer layer comprises Ga as a main component, and is a layered structure in which three or more buffer films are layered so that a composition ratio of Ga increases from a base body side of the buffer layer toward a crystalline oxide semiconductor film side;
at least two layers of the buffer films have a thickness of 200 nm or larger and 650 nm or smaller;
the base body has a corundum structure; and the crystalline oxide semiconductor film is the crystalline oxide semiconductor film according to any one of the above [1] to [19].

[21] The layered structure according to the above [20], wherein a thickness of all of the buffer films in the buffer layer is 200 nm or larger and 650 nm or smaller.

[22] The layered structure according to the above [20] or [21], wherein the buffer layer comprises Al, and is a layered structure in which three or more buffer films are layered so that a composition ratio of Al decreases from the base body side of the buffer layer toward the crystalline oxide semiconductor film side.

[23] A semiconductor device comprising at least one of the crystalline oxide semiconductor film according to any one of the above [1] to [19] and the layered structure according to any one of the above [20] to [22].

[24] The semiconductor device according to the above [23], wherein the semiconductor device is any one of a semiconductor laser, a diode and a transistor.

The present invention is not limited to the above embodiments. The above embodiments are merely examples, and any embodiment having substantially the same configuration as the technical idea described in the claims of the present invention and exhibiting the same operation and effect is included in the technical scope of the present invention.

**Claims**

1. A crystalline oxide semiconductor film, wherein
the crystalline oxide semiconductor film is a uniaxially oriented film containing $\alpha$-Ga$_2$O$_3$ as a main component, wherein a total area (C2) of peaks of a rotational domain with respect to a total area (C1) of peaks of the crystalline oxide semiconductor film, which are obtained by $\varphi$ scan of X-ray diffraction measurement of an asymmetric plane of the crystalline oxide semiconductor film, is the total area (C2) of the peaks of the rotational domain being less than 5 counts with respect to 1,000,000 counts of the total area (C1) of the peaks of the crystalline oxide semiconductor film.

2. The crystalline oxide semiconductor film according to claim 1, wherein the total area (C2) of the peaks of the rotational domain is 0 count with respect to 1,000,000 counts of the total area (C1) of the peaks of the crystalline oxide semiconductor film.

3. A crystalline oxide semiconductor film, wherein
the crystalline oxide semiconductor film is a uniaxially oriented film containing $\alpha$-$Ga_2O_3$ as a main component, wherein a total area (C2) of peaks of a rotational domain with respect to a total area (C1) of peaks of the crystalline oxide semiconductor film, which are obtained by $\varphi$ scan of X-ray diffraction measurement of an asymmetric plane of the crystalline oxide semiconductor film, is the total area (C2) of the peaks of the rotational domain being 0 count with respect to 500,000 counts of the total area (C1) of the peaks of the crystalline oxide semiconductor film.

4. The crystalline oxide semiconductor film according to claim 1, wherein the crystalline oxide semiconductor film comprises a dopant.

5. The crystalline oxide semiconductor film according to claim 1, wherein a thickness of the crystalline oxide semiconductor film is 1 $\mu$m or larger.

6. The crystalline oxide semiconductor film according to claim 1, wherein Ga accounts for 90 atom% or more of metals contained in the crystalline oxide semiconductor film.

7. The crystalline oxide semiconductor film according to claim 1, wherein the crystalline oxide semiconductor film has a size with a diameter of 2 inches (50 mm) or larger.

8. The crystalline oxide semiconductor film according to claim 1, wherein the crystalline oxide semiconductor film has a size with a diameter of 6 inches (150 mm) or larger.

9. The crystalline oxide semiconductor film according to claim 1, wherein a half-value width of a rocking curve in a plane parallel to a principal plane of the crystalline oxide semiconductor film is 25 arcsec or smaller, and a half-value width of a rocking curve in the asymmetric plane is 2500 arcsec or smaller.

10. The crystalline oxide semiconductor film according to claim 1, wherein the crystalline oxide semiconductor film has a c-plane as a principal plane.

11. The crystalline oxide semiconductor film according to claim 10, wherein a half-value width of a rocking curve of a (006) plane of the crystalline oxide semiconductor film is 25 arcsec or smaller.

12. The crystalline oxide semiconductor film according to claim 10, wherein a half-value width of a rocking curve of a (104) plane of the crystalline oxide semiconductor film is 2500 arcsec or smaller.

13. The crystalline oxide semiconductor film according to claim 1, wherein the number of cracks of the crystalline oxide semiconductor film is zero per $mm^2$.

14. The crystalline oxide semiconductor film according to claim 1, wherein a content ratio [%] of the rotational domain is less than 0.0005%, which is calculated from a total peak area (C1) of the crystalline oxide semiconductor film and the total area (C2) of the peaks of the rotational domain, according to C1/C2 $\times$100.

15. The crystalline oxide semiconductor film according to claim 14, wherein the content ratios of the rotational domains are all less than 0.0005% in the measurements at five points in a plane of the crystalline oxide semiconductor film.

16. The crystalline oxide semiconductor film according to claim 14, wherein a coefficient of variation of the content ratios of the rotational domains is less than 0.35, which are measured at five points in a plane of the crystalline oxide semiconductor film.

17. The crystalline oxide semiconductor film according to claim 1, wherein a content ratio [%] of the rotational domain is less than 0.0002%, which is calculated from a total peak area (C1) of the crystalline oxide semiconductor film and the total area (C2) of the peaks of the rotational domain, according to C1/C2 ×100.

18. The crystalline oxide semiconductor film according to claim 17, wherein the content ratios of the rotational domains are all less than 0.0002% in the measurements at five points in a plane of the crystalline oxide semiconductor film.

19. The crystalline oxide semiconductor film according to claim 1, wherein the count number of peaks having the highest intensity among peaks of the rotational domain is 0 count with respect to 150,000 counts of the count number of the peaks having the highest intensity among peaks that are obtained by φ scan of the X-ray diffraction measurement of the asymmetric plane of the crystalline oxide semiconductor film.

20. A layered structure comprising: a base body; and a crystalline oxide semiconductor film layered on the base body via a buffer layer, wherein

the buffer layer comprises Ga as a main component, and is a layered structure in which three or more buffer films are layered so that a composition ratio of Ga increases from a base body side of the buffer layer toward a crystalline oxide semiconductor film side;
at least two layers of the buffer films have a thickness of 200 nm or larger and 650 nm or smaller;
the base body has a corundum structure; and the crystalline oxide semiconductor film is the crystalline oxide semiconductor film according to claim 1.

21. The layered structure according to claim 20, wherein a thickness of all of the buffer films in the buffer layer is 200 nm or larger and 650 nm or smaller.

22. The layered structure according to claim 20, wherein the buffer layer comprises Al, and is a layered structure in which three or more buffer films are layered so that a composition ratio of Al decreases from the base body side of the buffer layer toward the crystalline oxide semiconductor film side.

23. A semiconductor device comprising at least one of the crystalline oxide semiconductor film according to any one of claims 1 to 19 and the layered structure according to any one of claims 20 to 22.

24. The semiconductor device according to claim 23, wherein the semiconductor device is any one of a semiconductor laser, a diode and a transistor.

FIG. 1

FIG. 2

FIG. 3

FIG. 4

FIG. 5

FIG. 6

FIG. 7

FIG. 8

FIG. 9

FIG. 10

FIG. 11

<u>820</u>

804

804a

805a

816

805

806

FIG. 12

903b  903a

909a

<u>900</u>

930a

904a

904b

902b

905b

916a

902a

905a

906a

<u>920a</u>

903d  903c

909b

909

909c

930b

904c

907

904d

912

902d

909d

902c

905c

910

908

906b

905d

916b

914

<u>950</u>

913

920b

<u>940</u>

FIG. 13

FIG. 14

FIG. 15

## INTERNATIONAL SEARCH REPORT

| International application No. |
| --- |
| **PCT/JP2023/043114** |

**A.    CLASSIFICATION OF SUBJECT MATTER**

*H01L 21/365*(2006.01)i; *C23C 16/40*(2006.01)i; *C30B 29/16*(2006.01)i; *H01L 21/329*(2006.01)i; *H01L 21/338*(2006.01)i; *H01L 21/36*(2006.01)i; *H01L 21/368*(2006.01)i; *H01L 29/12*(2006.01)i; *H01L 29/739*(2006.01)i; *H01L 29/778*(2006.01)i; *H01L 29/78*(2006.01)i; *H01L 29/812*(2006.01)i; *H01L 29/872*(2006.01)i; *H01L 33/26*(2010.01)i

FI:    H01L21/365; C23C16/40; C30B29/16; H01L21/36; H01L21/368 Z; H01L29/78 652T; H01L29/78 653A; H01L29/78 655A; H01L29/80 H; H01L29/86 301D; H01L29/86 301P; H01L33/26

According to International Patent Classification (IPC) or to both national classification and IPC

**B.    FIELDS SEARCHED**

Minimum documentation searched (classification system followed by classification symbols)

H01L21/365; C23C16/40; C30B29/16; H01L21/329; H01L21/338; H01L21/36; H01L21/368; H01L29/12; H01L29/739; H01L29/778; H01L29/78; H01L29/812; H01L29/872; H01L33/26

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
| --- | --- | --- |
| X | JP 2016-157878 A (FLOSFIA INC.) 01 September 2016 (2016-09-01) paragraphs [0013]-[0048] | 1-8, 14-19, 23, 24 |
| Y | paragraphs [0013]-[0048] | 9-13 |
| A | paragraphs [0013]-[0048] | 20-22 |
| Y | JP 2022-094811 A (SHIN-ETSU CHEMICAL CO., LTD.) 27 June 2022 (2022-06-27) paragraphs [0076]-[0088] | 9-12 |
| A | paragraphs [0076]-[0088] | 20-22 |
| Y | WO 2022/075139 A1 (NGK INSULATORS LTD.) 14 April 2022 (2022-04-14) paragraph [0023] | 9-12 |
| A | paragraph [0023] | 20-22 |

☑ Further documents are listed in the continuation of Box C.          ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **10 January 2024** | **23 January 2024** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

**EP 4 632 797 A1**

**INTERNATIONAL SEARCH REPORT**

International application No.

**PCT/JP2023/043114**

**C. DOCUMENTS CONSIDERED TO BE RELEVANT**

| Category* | Citation of document, with indication, where appropriate, of the relevant passages | Relevant to claim No. |
|---|---|---|
| Y | WO 2020/261355 A1 (NGK INSULATORS LTD.) 30 December 2020 (2020-12-30) paragraphs [0012]-[0016] | 13 |
| A | paragraphs [0012]-[0016] | 20-22 |
| A | JP 2016-156073 A (FLOSFIA INC.) 01 September 2016 (2016-09-01) entire text, all drawings | 20-22 |
| A | WO 2020/261574 A1 (NGK INSULATORS LTD.) 30 December 2020 (2020-12-30) entire text, all drawings | 20-22 |
| A | WO 2020/194803 A1 (NGK INSULATORS LTD.) 01 October 2020 (2020-10-01) entire text, all drawings | 20-22 |

Form PCT/ISA/210 (second sheet) (July 2022)

**INTERNATIONAL SEARCH REPORT**
**Information on patent family members**

International application No.

**PCT/JP2023/043114**

| Patent document cited in search report | | | Publication date (day/month/year) | Patent family member(s) | | | Publication date (day/month/year) |
|---|---|---|---|---|---|---|---|
| JP | 2016-157878 | A | 01 September 2016 | (Family: none) | | | |
| JP | 2022-094811 | A | 27 June 2022 | (Family: none) | | | |
| WO | 2022/075139 | A1 | 14 April 2022 | US paragraph [0028] CN | 2023/0122462 116490645 | A1 A | |
| WO | 2020/261355 | A1 | 30 December 2020 | (Family: none) | | | |
| JP | 2016-156073 | A | 01 September 2016 | (Family: none) | | | |
| WO | 2020/261574 | A1 | 30 December 2020 | (Family: none) | | | |
| WO | 2020/194803 | A1 | 01 October 2020 | US entire text, all drawings CN | 2021/0404089 113574214 | A1 A | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2013058637 A
- JP 2015017027 A
- JP 6876895 B
- JP 7016489 B
- JP 7265624 B

**Non-patent literature cited in the description**

- **KENTARO KANEKO**. Growth and physical properties of corundum-structured gallium oxide-based mixed crystal thin film. *Doctoral thesis of Kyoto University*, March 2013